# EUROPÄISCHE PATENTSCHRIFT

(11) **EP 2 915 901 B1**
(45) Veröffentlichungstag und Bekanntmachung des Hinweises auf die Patenterteilung: **27.02.2019**
(21) Anmeldenummer: 14158269.2
(22) Anmeldetag: 07.03.2014
(51) Int. Cl.: C23C 16/455, H01J 37/32

(54) **Vorrichtung zur Plasmaprozessierung mit Prozessgaszirkulation in multiplen Plasmen**
Device for plasma processing with process gas circulation in multiple plasmas
Dispositif de traitement par plasma avec recirculation de gaz de processus dans de multiples plasmas

(43) Veröffentlichungstag der Anmeldung: 09.09.2015
(73) Patentinhaber: Meyer Burger (Germany) AG, 09337 Hohenstein-Ernstthal (DE)
(72) Erfinder: Schlemm, Hermann, Dr., 07751 Milda (DE); Kehr, Mirko, 09439 Amtsberg (DE); Ansorge, Erik, 09131 Chemnitz (DE); Decker, Daniel, 09427 Ehrenfriedersdorf (DE)
(74) Vertreter: Kailuweit & Uhlemann Patentanwälte Partnerschaft mbB

(56) Entgegenhaltungen:
- EP-A2- 1 073 091
- EP-A2- 1 243 667
- EP-A2- 2 045 358
- JP-A- S60 189 220
- JP-A- 2002 203 792
- US-A- 4 468 283
- US-A1- 2005 279 731

## Beschreibung

Die Erfindung betrifft eine Vorrichtung zur Plasmaprozessierung mit Niedertemperaturplasmen, die in einer Prozesskammer mehrere Plasmaprozesszonen aufweist und bei der ein Teil des aus der Prozesskammer abgeführten Abgases wieder dem Prozessgas für die Plasmaprozesse zugeführt wird.

Plasmaprozesse werden beispielsweise in der Solarzellenherstellung, der Mikroelektronik oder der Veredlung von Substratoberflächen (z. B. Glas) zur Abscheidung oder Entfernung von Schichten oder Partikeln oder zur Dotierung von Schichten, zum Beispiel durch Plasmaimmersions-Ionenimplantation, genutzt.

In der EP 2 045 358 A2, der JP 2002 203792 A und der US 2005/279731 A1 sind jeweils Vorrichtungen zur Plasmaprozessierung von Substraten beschrieben, die jeweils nur eine Plasmaprozesszone aufweisen. Um den Gasverbrauch zu senken, den Ausstoß schädlicher Abgase durch eine effektivere Umsetzung des verwendeten Prozessgases zu reduzieren und die Kosten der Bearbeitung zu verringern, weisen die Vorrichtungen der genannten Druckschriften Gasrückführsysteme auf, so dass das aus der Bearbeitungskammer abgesaugte Prozessgas dem Plasmaprozess erneut zugeführt wird. Auch aus der EP 1 243 667 A2 ist eine solche Gasrückführung für eine Vakuumbearbeitungskammer bekannt. Die US 4,468,283 A nutzt eine Gasrückführung zur Homogenisierung der Beschichtung über ein die Ausdehnung eines Substrates hinweg.

In der EP 1 073 091 A2 wird eine Durchlaufanlage beschrieben, bei der ein Substrat bei seiner Bewegung durch die Anlage mehrere Plasmaprozesszonen durchläuft. Um außergewöhnliche Entladungen innerhalb einer Plasmaprozesszone zu vermeiden und damit die Homogenität der Schichtabscheidung in dieser Plasmaprozesszone zu gewährleisten, wird die dem Plasma ausgesetzte Elektrodenoberfläche mit einer speziellen Schutzschicht überzogen und der Abstand zwischen den Elektroden sowie die Anregungsfrequenz werden geeignet gewählt. Das Prozessgas wird durch einen Gaseinlass in die Prozesskammer eingeführt und verteilt sich von dort aus auf die einzelnen Plasmaprozesszonen.

Um den Durchsatz bei der Plasmaprozessierung zu erhöhen, werden batch-Systeme, in denen mehrere Substrate gleichzeitig behandelt werden, verwendet. Dabei können die Substrate mit der zu prozessierenden Oberfläche neben- oder übereinander angeordnet sein. Solch ein batch-System ist beispielsweise in der JP S60 189220 A beschrieben, bei dem mehrere Substrate in einem Substratträger (boat) angeordnet sind. Das Prozessgas wird dabei über mehrere Gaseinlässe und mehrere Gasauslässe in die Prozesskammer zu- bzw. aus ihr abgeführt.

Aus der US 4,287,851 B und der EP 0 143 479 A1 sind Anlagen bekannt, bei denen jedem Substrat eine Plasmaprozesszone, die getrennt von den anderen Plasmaprozesszonen betrieben wird, zugeordnet ist.

Das während der Plasmaprozessierung genutzte Prozessgas wird dabei entweder nur an einer Stelle in die Prozesskammer eingeführt und verteilt sich von dort aus auf die einzelnen Plasmaprozesszonen oder es wird den einzelnen Plasmaprozesszonen jeweils über separate Auslassöffnungen (z. B. Düsen) zugeführt. Dabei strömt das Prozessgas vorteilhafterweise durch die Plasmaprozesszone hindurch.

Durch Unterschiede in den Bedingungen zur Plasmaerzeugung, in den Randbedingungen für ein jeweiliges Substrat (beispielsweise Umgebungstemperatur) sowie weitere Inhomogenitäten innerhalb der Prozesskammer kann es zu unterschiedlichen Ergebnissen der Prozessierung über die Vielzahl der gleichzeitig prozessierten Substrate kommen. Diese können beispielsweise unterschiedliche Abscheide- oder Ätzraten oder unterschiedliche Zusammensetzungen der abgeschiedenen Schichten oder unterschiedliche Dotiermengen sein.

Bei großen Substraten kommt es darüber hinaus zu einer Inhomogenität des Prozesses über die laterale Ausdehnung des Substrates hinweg, da das Prozessgas sich auf seinem Transportweg durch die Plasmaprozesszone in seiner Zusammensetzung verändert. Beispielsweise nimmt die Anzahl der reaktionsfähigen Bestandteile durch die bereits erfolgte Reaktion solcher Bestandteile über die Länge des Substrates in Richtung der Prozessgasströmung ab. Daher sinkt auch die abgeschiedene oder entfernte Schichtdicke in dieser Substratrichtung.

Um das zuletzt genannte Problem zu beheben, ist das Pulsen der erzeugten Plasmen bekannt. Dabei werden die Plasmen durch einen kurzen Puls nur für kurze Zeit gezündet, während die Plasmen die meiste Zeit (ca. 90 %) eines Zyklus ausgeschaltet sind. In dieser Auszeit des Plasmas kann sich neues, unverbrauchtes Prozessgas über das gesamte Substrat verteilen, so dass in der Zeit des gezündeten Plasmas an allen Stellen des Substrates gleiche Abscheide- oder Ätzraten erreicht werden können. Jedoch führt dies zu einer wesentlichen Verlängerung des Bearbeitungsprozesses, da effektiv nur 10 % der Gesamtzeit genutzt werden.

Aufgabe der vorliegenden Erfindung ist es somit, eine Vorrichtung zur Plasmaprozessierung von mehreren Substraten mit mehreren Plasmaprozesszonen zur Verfügung zu stellen, die geeignet ist, Inhomogenitäten der Plasmaprozessierung zwischen einzelnen Substraten, die aus Unterschieden des Plasmaprozesses in verschiedenen Plasmaprozesszonen entstehen, zu reduzieren. Weiterhin ist es Aufgabe der vorliegenden Erfindung, eine Vorrichtung zur Plasmaprozessierung zur Verfügung zu stellen, die auch Inhomogenitäten der Plasmaprozessierung über ein Substrat hinweg reduziert.

Diese Aufgabe wird gelöst durch die Vorrichtung nach Anspruch 1. Vorteilhafte Ausführungsformen finden sich in den Unteransprüchen.

Die erfindungsgemäße Vorrichtung zur Plasmaprozessierung umfasst eine Prozesskammer mit mindestens zwei von einem Prozessgas durchströmten Plasmaprozesszonen, einem Gaseinlass, der geeignet ist, das Prozessgas den mindestens zwei Plasmaprozesszonen zuzuführen, und einem Gasauslass, der geeignet ist, ein Abgas aus der Prozesskammer auszulassen, sowie eine Zirkulationseinheit mit einer Zirkulationsleitung und einer Zirkulationspumpe, wobei die Zirkulationseinheit geeignet ist, mindestens einen Teil des Abgases in den Gaseinlass einzuspeisen und wobei das in den Gaseinlass eingespeiste Abgas eine Mischung von Gasen, die aus mindestens zwei der Plasmaprozesszonen austreten, ist.

Generell wird unter dem Begriff "Gas", "Prozessgas" oder "Abgas" in dieser Anmeldung jede Form von Gas oder Gasgemischen verstanden, die für die Plasmaprozessierung geeignet sind oder bei dieser entstehen.

Der Gaseinlass ist dabei beispielsweise durch mindestens eine mit einer Gasleitung verbundene Öffnung in der Wandung der Prozesskammer, durch mindestens eine in die Prozesskammer einragende Gasleitung (Rohr) oder eine mit mindestens einer Gasleitung verbundene Einlasskammer mit einer oder mehreren Öffnungen, aus denen das Prozessgas in die Prozesskammer einströmt, realisiert. In gleicher Weise ist der Gasauslass beispielsweise durch mindestens eine mit einer Abgasleitung verbundene Öffnung in der Wandung der Prozesskammer, durch mindestens eine in die Prozesskammer einragende Abgasleitung (Rohr) oder eine mit mindestens einer Abgasleitung verbundene Auslasskammer mit einer oder mehreren Öffnungen, aus denen das Prozessgas aus der Prozesskammer einströmt, realisiert.

Wie bereits oben beschrieben, können unterschiedliche Plasmaprozesszonen unterschiedliche Raten der Umsetzung der Bestandteile des Prozessgases, beispielsweise in Radikale, Ionen oder Reaktionsprodukte, aufweisen. Durch die Mischung von Abgasen aus mindestens zwei der Plasmaprozesszonen und deren erneute Einspeisung in den Gaseinlass, werden die bereits umgesetzten, aber auch die noch nicht umgesetzten Bestandteile des Prozessgases aus den mindestens zwei der Plasmaprozesszonen vermischt und damit eine Homogenisierung des Prozessgases, das den mindestens zwei Plasmaprozesszonen zugeführt wird, erreicht. Dies reduziert die Inhomogenität der Plasmaprozessierung zwischen einzelnen Substraten, die aus Unterschieden des Plasmaprozesses in verschiedenen Plasmaprozesszonen entstehen.

Darüber hinaus wird das Prozessgas besser für den jeweiligen Plasmaprozess ausgenutzt, da zum einen noch nicht für die Abscheidung oder Entfernung von Schichten genutzte Bestandteile des Prozessgases erneut dem Plasmaprozess zugeführt werden und zum zweiten das Prozessgas damit schon reaktive oder bereits angeregte Bestandteile enthält, die eine geringere Anregung für die angestrebte Reaktion benötigen als ein bisher noch nicht durch ein Plasma angeregtes Prozessgas. Damit sind sowohl eine Verringerung des Gasverbrauches, das heißt des Verbrauches an frischem Prozessgas, als auch die Erhöhung der Abscheide- oder Ätzrate für den Plasmaprozess erreichbar.

Vorzugsweise umfasst die Zirkulationseinheit ein Regelventil, wobei das Regelventil und die Zirkulationspumpe so ausgelegt sind, dass das Verhältnis des Gasstromes des über die Zirkulationsleitung in den Gaseinlass eingespeisten Abgases zu dem Gasstrom von einem in den Gaseinlass eingespeisten, vom Abgas verschiedenen Gases in einem Bereich kleiner als 100 liegt. Ein typischer und bevorzugter Wert für das Verhältnis liegt zwischen 8 und 12, besonders bevorzugt bei 10. Das heißt, ein um ein Vielfaches größerer Gasfluss als der Gasfluss eines frisch der Plasmaprozessierung zugeführten Gases wird durch die Zirkulationseinheit aus dem Abgas entnommen und dem Gaseinlass und damit der Plasmaprozessierung wieder zugeführt. Dadurch wird die Strömungsgeschwindigkeit des Prozessgases durch die Plasmaprozesszonen signifikant erhöht und die Aufenthaltszeit des Prozessgases in der jeweiligen Plasmaprozesszone signifikant gesenkt, beispielsweise um ca. das 10fache. Damit sinkt auch der plasmachemische Abbaugrad des Prozessgases beim Durchgang durch die jeweilige Plasmaprozesszone, wodurch eine homogenere Zusammensetzung der Bestandteile des Prozessgases in der Plasmaprozesszone über die Länge des Substrates in Strömungsrichtung des Gases und letztlich eine homogenere Dicke der abgeschiedenen oder entfernten Schicht über die Ausdehnung des Substrates hinweg erreicht wird. Darüber hinaus wird der oben beschriebene Effekt der erneuten Zuführung von bereits angeregten Gasbestandteilen verstärkt, was zu einer weiteren Erhöhung der Abscheide- oder Ätzrate führt.

In einer Ausführungsform der erfindungsgemäßen Vorrichtung ist die Zirkulationsleitung mit einer Gaszuführungsleitung verbunden, die geeignet ist, ein von dem Abgas verschiedenes Gas in den Gaseinlas einzuspeisen. Dieses Gas ist ein frisches Gas oder Gasgemisch, das eines, mehrere oder alle Bestandteile des Prozessgases enthalten kann und dazu dient, den Plasmaprozess zu starten und die durch die Plasmaprozessierung verbrauchten Bestandteile des Prozessgases zu ersetzen. Damit werden das frisch zugeführte Gas und das über die Zirkulationsleitung dem Plasmaprozess wieder zugeführte Abgas bereits in der Gaszuführungsleitung, die mit dem Gaseinlass verbunden ist, vermischt und es ist nur eine Gaszuführungsleitung zur Einspeisung sowohl des frisch zugeführten Gases als auch des rückgeführten Abgases in die Prozesskammer notwendig.

In einer bevorzugten Ausführungsform ist der Gaseinlass mit zwei Gaszuführungsleitungen verbunden, wobei eine erste Gaszuführungsleitung direkt mit der Zirkulationsleitung und eine zweite Gaszuführungsleitung mit einer Vorrichtung zur Bereitstellung eines von dem Abgas verschiedenen Gases verbunden ist. Die zweite Gaszuführungsleitung ist damit geeignet, ein frisches Gas oder ein frisches Gasgemisch dem Prozessgas zuzuführen, so dass durch die Plasmaprozessierung verbrauchte Bestandteile des Prozessgases ersetzt werden können.

Vorzugsweise ist der Gaseinlass als Gaseinlass-Mischkammer ausgebildet, die mindestens zwei Ausströmsystem mit jeweils einer oder mehreren Öffnungen aufweist. Jedes Ausströmsystem ist dabei jeweils einer der mindestens zwei Plasmaprozesszonen zugeordnet, so dass das Prozessgas aus den Öffnungen des jeweiligen Ausströmsystems zu der zugeordneten Plasmaprozesszone strömt. Die mehreren Öffnungen eines Ausströmsystems weisen vorzugsweise eine solche Anordnung und Größe auf, dass das Prozessgas gleichmäßig oder in einer den Plasmabedingungen der Plasmaprozesszone angepassten Art der Plasmaprozesszone zugeführt wird. Beispielsweise können im Randbereich der Plasmaprozesszone die Öffnungen mit einem geringeren Abstand zueinander angeordnet sein oder andere Leitwerte aufweisen als die Öffnungen in einem mittleren Bereich der Plasmaanregungszone. Darüber hinaus können die einzelnen Ausströmsysteme, das heißt unterschiedlichen Plasmaprozesszonen zugeordnete voneinander verschiedene Ausströmsysteme, unterschiedliche Anordnungen und/oder Leitwerte der Öffnungen aufweisen. Vorzugsweise weisen die Öffnungen der Ausströmsysteme einen gleichen Leitwert auf. Neben der definierten Zuführung des Prozessgases zu den einzelnen Plasmaprozesszonen ist die Einlasskammer darüber hinaus geeignet, eine Vermischung des über die Zirkulationsleitung eingespeisten Abgases und des von dem Abgas verschiedenen eingespeisten Gases zu gewährleisten. Dies ist insbesondere dann von Vorteil, wenn das über die Zirkulationsleitung eingespeiste Abgas und das von dem Abgas verschiedene eingespeiste Gas über zwei voneinander getrennte Gaszuführungsleitungen in den Gaseinlass eingespeist werden. Die Gaseinlass-Mischkammer kann dabei außen an der Wandung der Prozesskammer oder innerhalb der Prozesskammer, anliegend an die Wandung oder von dieser beabstandet, angeordnet sein.

Wenn der Gaseinlass mit zwei Gaszuführungsleitungen verbunden ist, von denen eine erste der Zuführung des Abgases und eine zweite der Bereitstellung eines von dem Abgas verschiedenen Gases dient, wie oben beschrieben, dann weist die Gaseinlass-Mischkammer in einer besonders bevorzugten Ausführungsform mindestens zwei Unterkammern auf, wobei jede Unterkammer ein separates Ausströmsystem aufweist, aus dem das Prozessgas zu mindestens einer Plasmaprozesszone strömt und jeweils mindestens einer der Plasmaprozesszonen zugeordnet ist. Dabei ist jeder Unterkammer mindestens eine Dosiereinrichtung zugeordnet, die geeignet ist, die Menge des eingespeisten Abgases oder die Menge des vom Abgas verschiedenen eingespeisten Gases für die jeweilige Unterkammer separat einzustellen.

Vorzugsweise ist der Gasauslass durch eine Gasauslass-Mischkammer realisiert, die mindestens zwei Einströmsysteme mit jeweils einer oder mehreren Öffnungen aufweist, durch die das Abgas aus den Plasmaprozesszonen in die Gasauslass-Mischkammer einströmt, wobei jedes Einströmsystem jeweils einer der mindestens zwei Plasmaprozesszonen zugeordnet ist. Die mehreren Öffnungen eines Einströmsystems weisen vorzugsweise eine solche Anordnung und Größe auf, dass das Prozessgas gleichmäßig oder in einer den Plasmabedingungen der Plasmaprozesszone angepassten Art aus der zugeordneten Plasmaprozesszone abgeführt wird. Hier gilt das bereits mit Bezug auf die Ausströmsysteme und deren Öffnungen Gesagte. Vorzugsweise weisen die Öffnungen der mindestens zwei Einströmsysteme einen gleichen Leitwert auf. Die Gasauslass-Mischkammer kann dabei außen an der Wandung der Prozesskammer oder innerhalb der Prozesskammer, anliegend an die Wandung oder von dieser beabstandet, angeordnet sein.

In einer bevorzugten Ausführungsform ist der Gasauslass mit einer Vorrichtung zur Gasabführung über eine Abgasleitung verbunden ist, und die Zirkulationsleitung ist an die Abgasleitung angeschlossen. Damit ist nur eine mit dem Gasauslass verbundene Abgasleitung notwendig. Die Vorrichtung zur Gasabführung, beispielsweise eine Vakuumpumpe, dient dabei zum einen der Einstellung eines definierten Druckes in der Prozesskammer als auch der Abführung des Abgases vom Gasauslass und damit der Regelung der Einspeisung des Prozessgases in die Prozesskammer.

In einer anderen bevorzugten Ausführungsform ist der Gasauslass mit einer Vorrichtung zur Gasabführung über eine Abgasleitung und getrennt davon mit der Zirkulationsleitung verbunden. Das heißt, der Gasauslass ist mit zwei Gasabführungsleitungen verbunden, von denen eine erste die Abgasleitung und eine zweite die Zirkulationsleitung ist. Dies ermöglicht die Anpassung sowohl der Abgasleitung und Zirkulationsleitung als auch der Vorrichtung zur Gasabführung und der Zirkulationspumpe an die einzustellenden Parameter und Reinheitsanforderungen. Beispielsweise soll die Zirkulationspumpe keine Verunreinigungen des zurückgeführten Abgases verursachen, wodurch höhere Ansprüche an die Zirkulationspumpe gestellt werden als an die an die Abgasleitung angeschlossene Vakuumpumpe.

Vorzugsweise umfasst die Zirkulationseinheit eine staubabscheidende Einrichtung, die bevorzugt in der Zirkulationsleitung vor der Zirkulationspumpe angeordnet ist.

Weiterhin vorzugsweise umfasst die Zirkulationseinheit eine Vorrichtung zur Entfernung von spezifischen Bestandteilen des Abgases, insbesondere von gasförmigen Bestandteilen. Dies können beispielsweise nicht weiter im Plasmaprozess verwendbare Reaktionsprodukte sein.

In der erfindungsgemäßen Vorrichtung zur Plasmaprozessierung sind der Gaseinlass und der Gasauslass baugleich ausgeführt und die Vorrichtung zur Plasmaprozessierung weist eine Umschalteinheit auf, die geeignet ist, in einem ersten Schaltzustand das über die Zirkulationsleitung eingespeiste Abgas und das von dem Abgas verschiedene eingespeiste Gas dem Gaseinlass zuzuführen und das Abgas vom Gasauslass abzuführen und in einem zweiten Schaltzustand das über die Zirkulationsleitung eingespeiste Abgas und das von dem Abgas verschiedene eingespeiste Gas dem Gasauslass zuzuführen und das Abgas vom Gaseinlass abzuführen. Damit ist die Vorrichtung zur Plasmaprozessierung geeignet, einen Wechsel in der Gaszirkulationsrichtung des in Prozesskammer und den Plasmaprozesszonen strömenden Gasstroms herbeizuführen. Damit kann die Dicke der abgeschiedenen oder entfernten Schicht über die Ausdehnung des Substrates hinweg noch besser homogenisiert, das heißt ausgeglichen, werden. Die Umschalteinheit umfasst vorzugsweise zwei Ventilgruppen mit je zwei Ventilen, wobei die Ventile der ersten Ventilgruppe jeweils entgegengesetzt zu den Ventilen der zweiten Ventilgruppe geschaltet werden. Jeweils ein Ventil jeder Ventilgruppe befindet sich im Abgaszweig der Vorrichtung und jeweils das andere Ventil jeder Ventilgruppe befindet sich im Zuführungszweig der Vorrichtung. Die Umschalteinheit ist vorzugsweise geeignet, den Schaltzustand, und damit die Gaszirkulationsrichtung, zwischen 5 und 25 mal pro Plasmaprozessierungvorgang zu wechseln. Ein Plasmaprozessierungvorgang ist beispielsweise die Beschichtung eines Substrates mit einer vorgegebenen Schichtdicke oder die Entfernung einer vorgegebenen Dicke einer Schicht von einem Substrat.

Vorzugsweise weist die Vorrichtung zur Plasmaprozessierung weiterhin eine Vorrichtung zum Bewegen einer Anordnung von Substraten, die in den Plasmaprozesszonen bearbeitet werden, entlang einer ersten Richtung in der Prozesskammer auf. Dabei umfasst die Prozesskammer mehrere Gaseinlässe und mehrere Gasauslässe, wobei die Gaseinlässe und die Gasauslässe alternierend entlang der ersten Richtung auf einer Seite der Prozesskammer angeordnet sind. Beispielsweise sind die Gasein- und Gasauslässe an der oberen Wandung der Prozesskammer angeordnet, wobei die Substrate lateral nebeneinander angeordnet sind und sich unterhalb der Plasmaprozesszonen, die entlang der ersten Richtung zwischen den jeweiligen Gasein- und Gasauslässen angeordnet sind, entlang bewegen. Dabei wird die Substratanordnung von dem Prozessgas angeströmt, aber nicht durchströmt. Dies entspricht einer sogenannten In-line-Anlage mit flachen, lateral nebeneinander angeordneten Einzelsubstraten, bei der das Prozessgas in eine Richtung entlang der Bewegungsrichtung der Substrate strömt. Das Abgas aus mindestens zwei Gasauslässen wird durch die Zirkulationseinheit gemischt und in die Gaseinlässe wieder eingespeist.

In einer anderen bevorzugten Ausführungsform sind der Gaseinlass und der Gasauslass an gegenüberliegenden Seiten der Prozesskammer angeordnet. Dabei können die Plasmaprozesszonen lateral nebeneinander oder vorzugsweise vertikal übereinander zwischen dem Gaseinlass und dem Gasauslass angeordnet sein.

Vorzugsweise weist die Vorrichtung zur Plasmaprozessierung weiterhin eine Vorrichtung zum Bewegen einer Anordnung von Substraten, die in den Plasmaprozesszonen bearbeitet werden, entlang einer ersten Richtung in der Prozesskammer auf. Dabei umfasst die Prozesskammer mehrere Gaseinlässe und mehrere, diesen zugeordnete Gasauslässe, wobei die Gaseinlässe und die Gasauslässe entlang der ersten Richtung derart angeordnet sind, dass ein spezifischer Gaseinlass auf einer Seite der Prozesskammer, die sich entlang der ersten Richtung erstreckt, und ein, diesem spezifischen Gaseinlass zugeordneter Gasauslass auf der gegenüberliegenden Seite der Prozesskammer angeordnet sind. Dabei sind die Substrate in der Substratanordnung lateral nebeneinander oder vorzugsweise vertikal übereinander zwischen einem spezifischen Gaseinlass und einem diesem gegenüberliegenden Gasauslass angeordnet, so dass die Substratanordnung und die dem jeweiligen Gaseinlass und Gasauslass zugeordneten Plasmaprozesszonen von dem Prozessgas durchströmt werden. Dies entspricht einer In-line-Anlage, in der auch Substrat-Stacks prozessiert werden können, bei der das Prozessgas in eine Richtung vertikal zur Bewegungsrichtung der Substrate strömt. Die Substrate können dabei während der Plasmaprozessierung bewegt werden oder quasistationär bearbeitet werden. Im zweiten Fall werden die Substrate von einer Position zwischen einem ersten Paar aus Gaseinlass und zugeordnetem Gasauslass zu einer anderen Position zwischen einem zweiten Paar aus Gaseinlass und zugeordnetem Gasauslass innerhalb der Prozesskammer bewegt, verbleiben jedoch während der Plasmaprozessierung unbewegt an der jeweiligen Position.

Der Gasauslass führt dabei vorzugsweise das Abgas aus mindestens zwei Plasmaprozesszonen, die von dem zugeordneten Gaseinlass mit Prozessgas versorgt werden, ab, mischt diese und führt sie mindestens dem zugeordneten Gaseinlass wieder zu.

In einer bevorzugten Ausführungsform umfasst die Vorrichtung zur Plasmaprozessierung genauso viele Zirkulationseinheiten wie Paare von Gaseinlässen und diesen zugeordnete Gasauslässe, wobei jedem spezifischen Paar aus Gaseinlass und zugeordnetem Gasauslass eine Zirkulationseinheit zugeordnet ist. Daher werden die Abgase aus einem spezifischen Gasauslass durch die zugeordnete Zirkulationseinheit ausschließlich in den zugeordneten Gaseinlass eingespeist.

Alternativ werden die Abgase mehrerer Gasauslässe miteinander gemischt und mindestens einem, bevorzugt mehreren Gaseinlässen wieder zugeführt. In einer besonders bevorzugten Ausführungsform werden die Abgase aus allen Gasauslässen gemischt und in alle Gaseinlässe eingespeist. Für diese Ausgestaltung ist nur eine Zirkulationseinheit notwendig.

In einer besonders bevorzugten Ausführungsform der Vorrichtung zur Plasmaprozessierung sind die Gaseinlässe und die zugehörigen Gasauslässe von zwei in der ersten Richtung hintereinander angeordneten Paaren von Gaseinlässen und diesen zugeordneten Gasauslässen so angeordnet, dass der Gaseinlass des einen Paares auf der selben Seite der Prozesskammer angeordnet ist wie der Gasauslass des anderen Paares. Damit sind entlang der ersten Richtung mindestens zwei Gaseinlässe und zwei Gasauslässe alternierend auf der selben Seite der Prozesskammer angeordnet. Mit dieser Anordnung können Inhomogenitäten über die Ausdehnung der Substrate in Strömungsrichtung des Prozessgases ausgeglichen werden, da die Strömungsrichtung des Prozessgases zwischen den beiden Paaren von Gaseinlass und zugeordnetem Gasauslass wechselt.

Im Folgenden wird die erfindungsgemäße Vorrichtung zur Plasmaprozessierung an Hand mehrerer Ausführungsbeispiele erläutert, ohne die Vorrichtung auf diese Beispiele zu beschränken. Insbesondere ist es möglich, Aspekte, die mit Bezug auf verschiedene Ausführungsbeispiele beschrieben werden, miteinander zu kombinieren, solange dies nicht ausdrücklich ausgeschlossen ist.

### Figuren

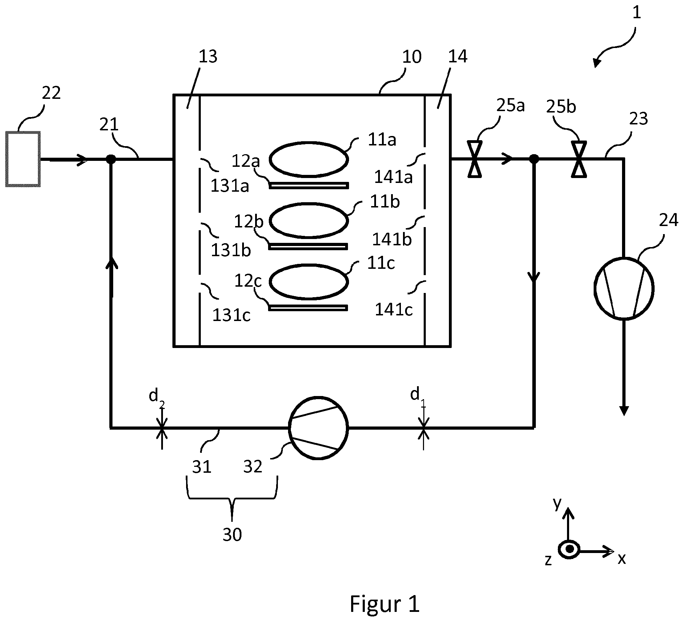

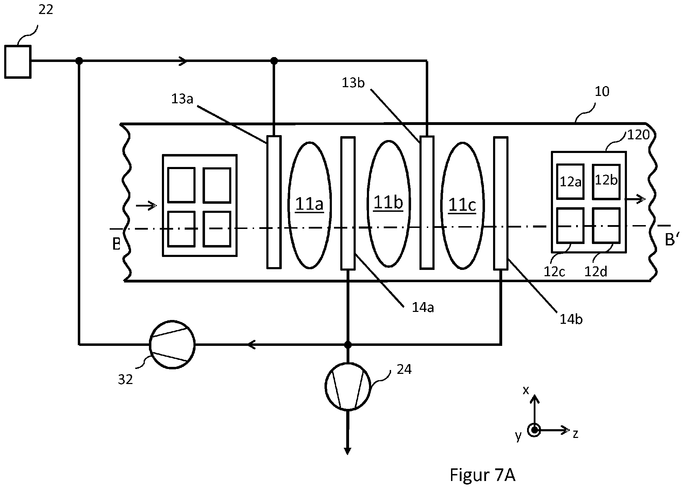

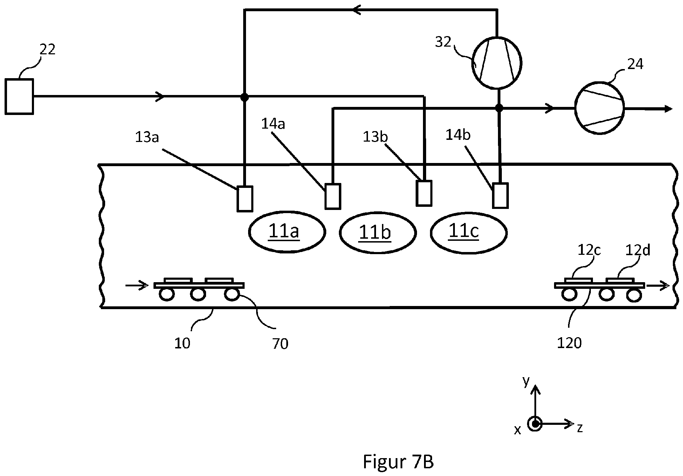

**Fig. 1** zeigt einen Querschnitt einer ersten Ausführungsform der erfindungsgemäßen Vorrichtung zur Plasmaprozessierung, bei der der Gaseinlass durch eine Einlasskammer realisiert ist und die Zirkulationsleitung mit einer Gaszuführungsleitung verbunden ist, die geeignet ist, ein vom Abgas verschiedenes Gas dem Gaseinlass zuzuführen. Darüber hinaus weist die erste Ausführungsform nur eine Abgasleitung auf, über die das Abgas aus dem Gasauslass abgeführt wird und mit der die Zirkulationsleitung verbunden ist.

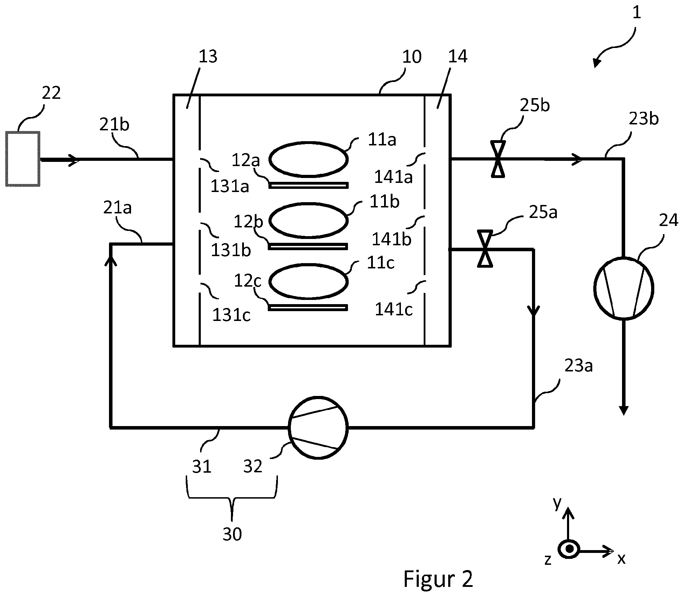

**Fig. 2** zeigt einen Querschnitt einer zweiten Ausführungsform der erfindungsgemäßen Vorrichtung zur Plasmaprozessierung, bei der der durch eine Einlasskammer realisierte Gaseinlass mit zwei Gaszuführungsleitungen verbunden ist, von denen eine geeignet ist, ein vom Abgas verschiedenes Gas dem Gaseinlass zuzuführen, und die andere die Zirkulationsleitung ist. Darüber hinaus weist die zweite Ausführungsform zwei Abgasleitungen auf, über die das Abgas aus dem Gasauslass abgeführt wird, von denen eine die Zirkulationsleitung ist.

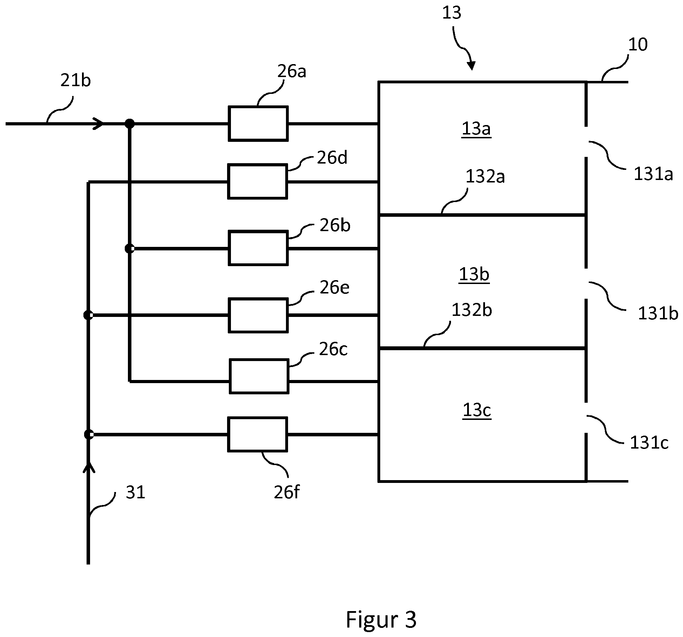

**Fig. 3** stellt eine Ausführungsform des Gaseinlasses dar, bei dem der Gaseinlass als Mischkammer mit mehreren Unterkammern ausgeführt ist. Dabei kann die Menge des eingespeisten Abgases und die Menge des vom Abgas verschiedenen eingespeisten Gases für jede Unterkammer separat mit Hilfe von Dosiereinrichtungen eingestellt werden.

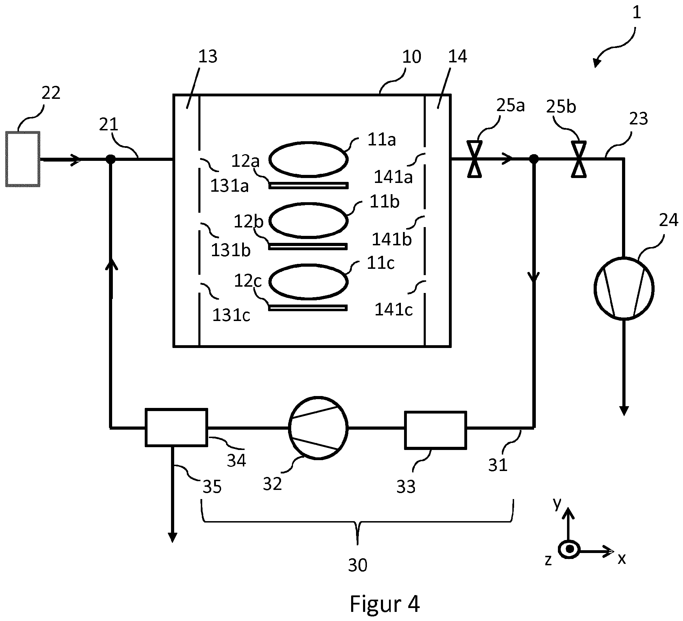

**Fig. 4** zeigt schematisch eine dritte Ausführungsform der erfindungsgemäßen Vorrichtung zur Plasmaprozessierung, bei der die Zirkulationseinheit weiterhin eine staubabscheidende Vorrichtung und eine Vorrichtung zur Entfernung von spezifischen, gasförmigen Bestandteilen des Abgases enthält.

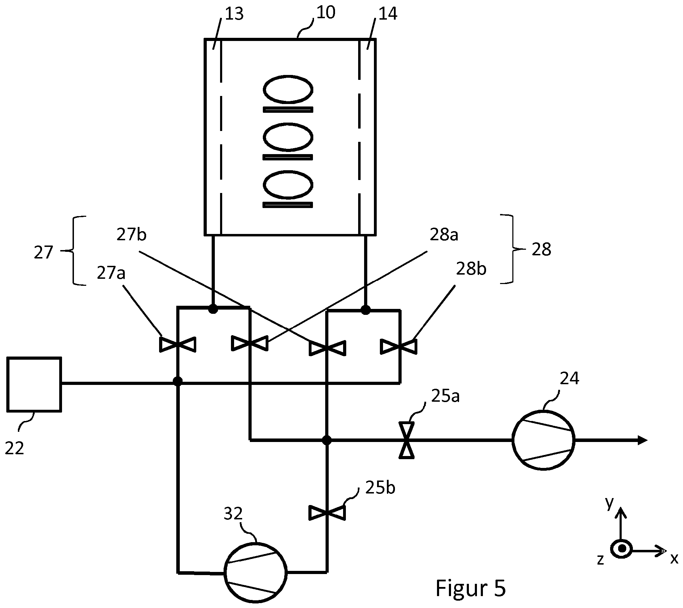

**Fig. 5** zeigt schematisch den Aufbau einer Ausführungsform der erfindungsgemäßen Vorrichtung zur Plasmaprozessierung inklusive der Umschalteinheit, mit der die Zirkulationsrichtung der Gase gewechselt werden kann.

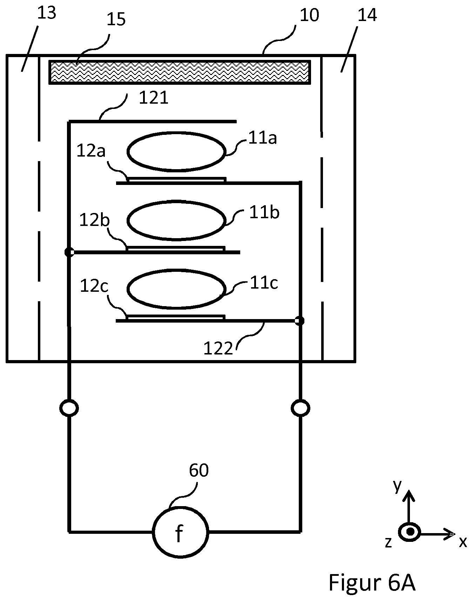

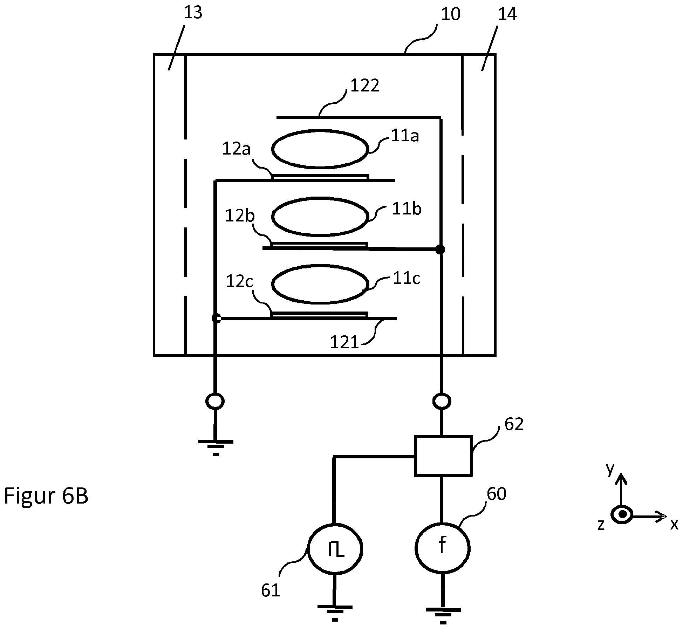

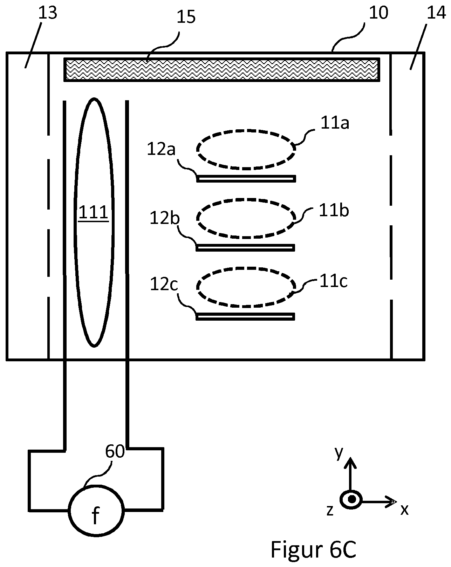

**Fig. 6A bis 6C** zeigen spezifische Ausführungsbeispiele für die Erzeugung des Plasmas und die elektrische Verschaltung der Substrathalterungen, wobei **Fig. 6A** ein Beispiel für eine ungepulste Plasmaerzeugung, **Fig. 6B** ein Beispiel für eine gepulste Plasmaerzeugung und **Fig. 6C** ein Beispiel für eine Remote Plasmaerzeugung zeigt.
Mit Bezug auf die **Figuren 7A** **und** **7B** wird eine vierte Ausführungsform der erfindungsgemäßen Vorrichtung zur Plasmaprozessierung erläutert, bei der die Substratanordnung unterhalb der Prozessgasströmung entlang geführt wird. Dabei zeigt **Fig. 7A** eine Draufsicht auf die Anlage, während **Fig. 7B** einen Querschnitt durch die Anlage in Bewegungsrichtung der Substratanordnung darstellt.

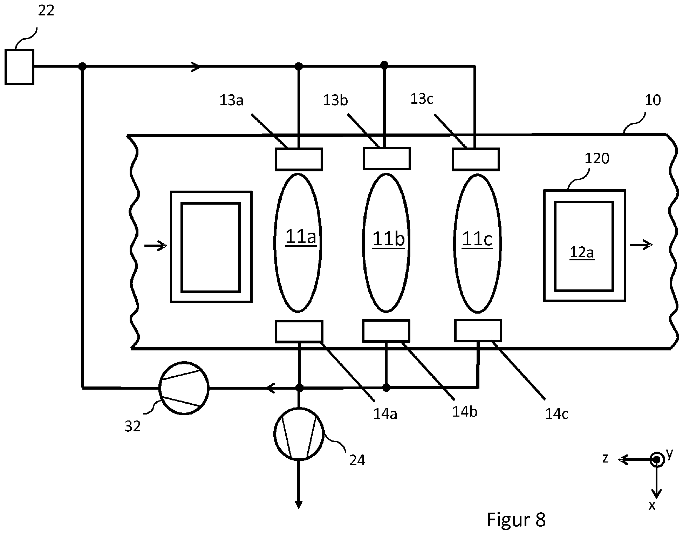

**Fig. 8** zeigt eine fünfte Ausführungsform der erfindungsgemäßen Vorrichtung zur Plasmaprozessierung, bei der die Substratanordnung von dem Prozessgas durchstömt wird und deren Querschnitt beispielsweise dem in der Fig. 1 gezeigten Querschnitt entspricht.

### Ausführungsbeispiele

In **Figur 1** ist eine erste Ausführungsform der erfindungsgemäßen Vorrichtung (1) zur Plasmaprozessierung in einem Querschnitt entlang der x-y-Ebene in einem dreidimensionalen kartesischen Koordinatensystem dargestellt. Die Vorrichtung (1) umfasst eine Prozesskammer (10), eine Gaszuführungsleitung (21), eine an die Gaszuführungsleitung (21) angeschlossene Vorrichtung zur Gasbereitstellung (22), eine Abgasleitung (23), eine an die Abgasleitung (23) angeschlossene Pumpe (24) und eine Zirkulationseinheit (30).

Die Prozesskammer (10) weist mehrere Plasmaprozesszonen (11a bis 11c) sowie einen Gaseinlass (13), der als Gaseinlass-Mischkammer realisiert ist, und einen Gasauslass (14), der als Gasauslass-Mischkammer realisiert ist, auf. In der in Figur 1 dargestellten Ausführungsform weist die Prozesskammer (10) drei Plasmaprozesszonen (11a bis 11c) auf. In anderen Ausführungsformen können auch nur zwei Plasmaprozesszonen oder mehr als drei Plasmaprozesszonen zwischen dem Gaseinlass (13) und dem Gasauslass (14) angeordnet sein. Die Plasmaprozesszonen dienen der Plasmaprozessierung von Substraten (12a bis 12c), die im dargestellten Fall jeweils unterhalb einer zugeordneten Plasmaprozesszone (11a bis 11c) angeordnet sind. In anderen Ausführungsformen können die Substrate auch oberhalb, innerhalb oder seitlich von der jeweiligen Plasmaprozesszone angeordnet sein. Die Substrate sind im dargestellten Fall vertikal übereinander, das heißt entlang der y-Achse und senkrecht zu ihrer lateralen Ausdehnung, in einem sogenannten Substrat-Stack angeordnet. In anderen Ausführungsformen können auch mehrere Substrate lateral nebeneinander, das heißt entlang der x-Achse oder entlang der z-Achse, angeordnet sein. Dann können auch die spezifischen Plasmaprozesszonen lateral nebeneinander angeordnet sein. Auch eine Kombination der lateralen und vertikalen Anordnung mehrerer Substrate neben- bzw. übereinander ist möglich.

Der Gaseinlass (13) ist auf einer ersten Seite der Prozesskammer (10) angeordnet, während der Gasauslass (14) auf einer zweiten Seite der Prozesskammer angeordnet ist, wobei die zweite Seite der Prozesskammer der ersten Seite gegenüberliegt. Sowohl die Einlasskammer des Gaseinlasses (13) als auch die Auslasskammer des Gasauslasses (14) sind innerhalb der Prozesskammer (10), das heißt an der Innenseite der Wandung der Prozesskammer (10), angeordnet. Die Substrate (12a bis 12c) sind zwischen der ersten und der zweiten Seite der Prozesskammer (10) angeordnet, so dass die Substratanordnung, das heißt die Gesamtheit der Substrate, von einem Prozessgas, das zwischen dem Gaseinlass und dem Gasauslass strömt, durchströmt wird. Der Gaseinlass (13) weist mehrere Ausströmöffnungen (131a bis 131c) auf, aus denen das Prozessgas zu den Plasmaprozesszonen (11a bis 11c) strömt, während der Gasauslass (14) mehrere Einströmöffnungen (141a bis 141c) aufweist, durch die das aus den Plasmaprozesszonen (11a bis 11c) austretende Abgas in den Gasauslass einströmt. In der in Figur 1 dargestellten Ausführungsform sind drei Ausströmöffnungen (131a bis 131c) und drei Einströmöffnungen (141a bis 141c) vorhanden. Obwohl dies in dem in Figur 1 dargestellten Querschnitt nicht ersichtlich ist, sind mehrere Ausströmöffnungen und mehrere Einströmöffnungen entlang der z-Richtung der Prozesskammer angeordnet. Die Ausströmöffnungen, aus denen das Prozessgas zu einer spezifischen Plasmaprozesszone (11a bis 11c) strömt, bilden dabei ein Ausströmsystem, das der spezifischen Plasmaprozesszone zugeordnet ist. In gleicher Weise bilden die Einströmöffnungen, durch die das aus einer spezifischen Plasmaprozesszone (11a bis 11c) austretende Abgas strömt, ein Einströmsystem, das der spezifischen Plasmaprozesszone zugeordnet ist. Die Ausströmöffnungen eines spezifischen Ausströmsystems und die Einströmöffnungen eines spezifischen Einströmsystems sind jeweils auf der selben Position bezüglich der y-Achse angeordnet.

In anderen Ausführungsformen können die Anzahl der Ausströmöffnungen sowie die Anzahl der Einströmöffnungen auch von drei verschieden, voneinander verschieden und auch für verschiedene Plasmaprozesszonen verschieden sein. Darüber hinaus können die Anzahl der Ausströmöffnungen für verschiedene Ausströmsysteme, die Anzahl der Einströmöffnungen für verschiedene Ausströmsysteme sowie die vertikale Position der Ausströmöffnungen in einem spezifischen Ausströmsystem und die vertikale Position der Einströmöffnungen in einem spezifischen Einströmsystem, das heißt deren Position mit Bezug auf die y-Achse, verschieden sein.

Die Gaseinlass-Mischkammer weist einen ausreichend großen Querschnitt in der x-y-Ebene und damit einen ausreichend kleinen Strömungsleitwert im Inneren auf, so dass das Prozessgas aus den Ausströmöffnungen (131a bis 131c) gleichverteilt in die mehreren Plasmaprozesszonen eingespeist werden kann. Vorteilhafterweise weisen die Ausströmöffnungen (131a bis 131c) derartig kleine Querschnitte und Abmessungen auf, dass an ihnen der Effekt der Gasverblockung auftritt.

Der Gaseinlass (13) ist mit der Gaszuführungsleitung (21) verbunden, über die das Prozessgas in den Gaseinlass (13) eingespeist wird. Das Prozessgas besteht dabei aus einer Mischung von frischem Gas, das von der Vorrichtung zur Gasbereitstellung (22) bereitgestellt wird, und von Abgas, das über die Zirkulationseinheit (30) vom Gasauslass (14) zum Gaseinlass (13) zurückgeführt wird. Das frische Gas und das Abgas mischen sich dabei bereits in der Gaszuführungsleitung (21) und darüber hinaus in der Gaseinlass-Mischkammer des Gaseinlasses (13). Die Menge des frischen Gases wird über eine Dosiereinrichtung, beispielsweise einem Mass Flow Controller, in der Vorrichtung zur Gasbereitstellung (22) geregelt.

Der Gasauslass (14) ist mit einer Abgasleitung (23) verbunden, an die eine Pumpe (24) angeschlossen ist. Die Pumpe (24) dient zum einen zum Absaugen des bei der Plasmaprozessierung entstehenden Abgases und zum anderen, zusammen mit in der Abgasleitung (23) angeordneten Regelventilen (25a, 25b) zur Einstellung eines definierten Drucks in der Prozesskammer (10). Dabei mischen sich die Abgase aus verschiedenen Plasmaprozesszonen (11a bis 11c) in der Gasauslass-Mischkammer des Gasauslasses (14) und in der Abgasleitung (23).

Die Zirkulationseinheit (30) umfasst eine Zirkulationsleitung (31) und eine Zirkulationspumpe (32). Die Zirkulationsleitung (31) ist in der ersten Ausführungsform der erfindungsgemäßen Vorrichtung zur Plasmaprozessierung mit der Abgasleitung (23) und der Gaszuführungsleitung (21) verbunden, so dass der Gaseinlass (13) nur mit der Gaszuführungsleitung (21) und der Gasauslass (14) nur mit der Abgasleitung (23) verbunden ist. Mit Hilfe der Zirkulationseinheit (30) wird ein Teil des Abgases dem Prozessgas wieder zugeführt, wobei der Anteil des wieder eingespeisten Abgases am gesamten Abgas über die Regelventile (25a, 25b) eingestellt wird. Damit wird auch der Anteil des wieder eingespeisten Abgases am gesamten Prozessgas reguliert, der gleich oder größer als der Gasfluss des frischen Gases ist. Beispielsweise wird ein um das 10fache größerer Gasfluss als der Gasfluss des frischen Gases dem Abgas entnommen und dem Gaseinlass wieder zugeführt. Als Zirkulationspumpe (32) ist eine Rootspumpe geeignet, die mit einem Kompressionsverhältnis von etwa 10 genügend Überdruck für die Gaszirkulation erzeugt. Da Rootspumpen mit Saugleistungen im Bereich von 250 bis 25 000 m³/h zur Verfügung stehen, können auch sehr große Prozesskammern mit einer ausreichenden Gaszirkulation versehen werden. Vorteilhafterweise werden Rootspumpen in halbleiterreiner Ausführung eingesetzt, so dass nur sehr kleine Leckraten in der Zirkulationseinheit (30) zusätzlich entstehen und die Verunreinigung des Prozessgases durch z. B. Getriebeöl aus den Rootspumpenwellenlagern vermieden wird. Der Durchmesser (di) der Zirkulationsleitung (31) vor der Zirkulationspumpe (32) in Richtung des gepumpten Gases kann dabei größer als der Durchmesser (d₂) der Zirkulationsleitung (31) nach der Zirkulationspumpe (32) in Richtung des gepumpten Gases sein.

**Figur 2** zeigt eine zweite Ausführungsform der erfindungsgemäßen Vorrichtung (1) zur Plasmaprozessierung in einem Querschnitt entlang der x-y-Ebene. Diese weist gegenüber der ersten Ausführungsform viele Gemeinsamkeiten auf, so dass diese nicht nochmals erläutert werden. Im Unterschied zur ersten Ausführungsform ist die Zirkulationseinheit (30) jedoch vollständig von der Zuführung eines frischen Gases und der mit der Pumpe (24) verbundenen Abgasleitung getrennt. Das heißt: Der Gaseinlass (13) ist mit zwei Gaszuführungsleitungen (21a, 21b) und der Gasauslass (14) ist mit zwei Abgasleitungen (23a, 23b) verbunden. Die erste Gaszuführungsleitung (21a) entspricht der Zirkulationsleitung (31), während die zweite Gaszuführungsleitung (21b) mit der Vorrichtung zur Gasbereitstellung (22) verbunden ist und der Einspeisung eines frischen Gases, das heißt eines vom Abgas verschiedenen Gases, in den Gaseinlass (13) dient. Damit mischen sich das über die erste Gaszuführungsleitung (21a) eingespeiste Abgas und das über die zweite Gaszuführungsleitung (21b) eingespeiste frische Gas erst in der Gaseinlass-Mischkammer des Gaseinlasses (13).

In anderen Ausführungsformen ist es weiterhin möglich, neben der zweiten Gaszuführungsleitung (21b) weitere Gaszuführungsleitungen, die weitere frische Gase in den Gaseinlass (13) einspeisen, vorzusehen. Dies ist insbesondere dann vorteilhaft, wenn die frisch zugeführten Gase unter Normaldruck zu Problem hinsichtlich der Sicherheit führen, wenn sie gemischt werden.

Die erste Abgasleitung (23a) entspricht der Zirkulationsleitung (31) und ist direkt mit der Zirkulationspumpe (32) verbunden, während die zweite Abgasleitung (23b) nur mit der Pumpe (24) verbunden ist. Daher weist die Gasauslass-Mischkammer des Gasauslasses (14) einen ausreichend großen Querschnitt in der x-y-Ebene und damit einen ausreichend kleinen Strömungsleitwert im Inneren auf, so dass sich die Abgase aus den mehreren Plasmaprozesszonen gut durchmischen. Mit dem in der Zirkulationsleitung (31) angeordneten Regelventil (25a) wird der Gasstrom des wieder in den Gaseinlass (13) eingespeisten Abgases eingestellt, während mit dem in der zweiten Abgasleitung (23b) angeordneten Regelventil (25b) der Druck in der Prozesskammer (10) eingestellt wird.

Merkmale der ersten und der zweiten Ausführungsform können auch kombiniert werden. Beispielsweise kann die Vorrichtung (1) zur Plasmaprozessierung auch zwei Gaszuführungsleitungen (21a, 21b) wie in Figur 2 dargestellt, aber nur eine Abgasleitung (23) wie in Figur 1 dargestellt umfassen.

**Figur 3** zeigt eine besonders bevorzugte Ausführungsform des Gaseinlasses (13) und der Gaszuführung im Detail. Zunächst weist die Gaseinlass-Mischkammer des Gaseinlasses (13) mehrere Unterkammern (13a bis 13c) auf, die voneinander durch Trennwände (132a, 132b) getrennt sind. Jede der Unterkammern (13a bis 13c) weist ein eigenes Ausströmsystem auf, die durch die Ausströmöffnungen (131a bis 131c) dargestellt sind. Jede Unterkammer (13a bis 13c) ist mit zwei Gaszuführungsleitungen verbunden, wobei jeweils eine davon geeignet ist, frisches Gas in die jeweilige Unterkammer (13a bis 13c) einzuspeisen, während die andere geeignet ist, das über die Zirkulationsleitung (31) zugeführte Abgas in die jeweilige Unterkammer (13a bis 13c) einzuspeisen. Darüber hinaus ist in jeder Gaszuführungsleitung eine Dosiereinrichtung (26a bis 26f) angeordnet, mit der die in die jeweilige Unterkammer (13a bis 13c) eingespeiste Menge an frischem Gas und die in die jeweilige Unterkammer (13a bis 13c) eingespeiste Menge an Abgas reguliert werden. So können mit Hilfe der Dosiereinrichtung 26a die in die Unterkammer 13a eingespeiste Menge an frischem Gas und mit Hilfe der Dosiereinrichtung 26d die in die Unterkammer 13a eingespeiste Menge an Abgas eingestellt werden. Mit der in Figur 3 dargestellten Ausführungsform sind damit Unterschiede in den Plasmaprozessbedingungen in den verschiedenen Plasmaprozesszonen (11a bis 11c), die jeweils einer Unterkammer (13a bis 13c) zugeordnet sind, durch eine unterschiedliche Zusammensetzung des Prozessgases ausgeglichen werden.

Obwohl in Figur 3 jeweils eine Dosiereinrichtung (26a bis 26f) in jeder Gaszuführungsleitung dargestellt ist, können auch nur Dosiereinrichtungen in den Gaszuführungsleitungen für die Zuführung des frischen Gases oder in den Gaszuführungsleitungen für das Abgas angeordnet sein. Darüber hinaus ist es auch möglich, dass verschiedene frische Gase in verschiedene Unterkammern (13a bis 13c) eingespeist werden. Weiterhin ist es möglich, dass die einzelnen Unterkammern (13a bis 13c) des Gaseinlasses (13) nicht vollständig voneinander durch die Trennwände (132a, 132b) getrennt sind, sondern dass diese Trennwände (132a, 132b) Öffnungen aufweisen, durch die sich ein Gas im gesamten Gaseinlass (13) ausbreiten kann. Damit kann beispielsweise die Einspeisung des Abgases für alle Unterkammern (13a bis 13c) über nur eine Gaszuführungsleitung realisiert werden, während die Zuführung von frischem Gas für jede Unterkammer (13a bis 13c) separat eingestellt werden kann.

**Figur 4** zeigt schematisch eine dritte Ausführungsform der erfindungsgemäßen Vorrichtung (1) zur Plasmaprozessierung. Diese entspricht im prinzipiellen Aufbau der ersten Ausführungsform, jedoch umfasst die Zirkulationseinheit (30) neben der Zirkulationsleitung (31) und der Zirkulationspumpe (32) auch eine staubabscheidende Vorrichtung (33) und eine Vorrichtung (34) zum Entfernen von spezifischen gasförmigen Bestandteilen des Abgases. Die staubabscheidende Vorrichtung (33) ist vorteilhafterweise vor der Zirkulationspumpe (32) in Richtung des gepumpten Gases angeordnet, so dass im Abgas enthaltene Staubpartikel bereits vor der Zirkulationspumpe (32) entfernt werden und damit eine Beeinträchtigung der Pumpleistung verhindert wird.

In einer anderen vorteilhaften Ausführungsform ist die staubabscheidende Vorrichtung (33) hinter der Zirkulationspumpe (32) in Richtung des gepumpten Gases angeordnet, so dass ein Druckabfall in der staubabscheidenden Vorrichtung (33) nicht so stark zum Tragen kommt. Weiterhin ist es möglich, auch mehrere solcher staubabscheidenden Vorrichtungen oder mehrstufige Vorrichtungen einzusetzen.

Die Vorrichtung (34) zum Entfernen von spezifischen gasförmigen Bestandteilen des Abgases dient zum Entfernen von nicht mehr in der Plasmaprozessierung einsetzbaren oder in zu großer Menge im Abgas vorhandenen Bestandteilen des Abgases. Dies können beispielsweise Reaktionsprodukte sein, die nicht mehr zum eigentlich durchzuführenden Plasmaprozess beitragen. Diese Bestandteile können durch die Vorrichtung (34) zum Entfernen ganz oder teilweise aus dem in der Zirkulationsleitung (31) transportiertem Abgas entfernt und über eine Abführleitung (35) abgeführt werden. Die Vorrichtung (34) zum Entfernen von spezifischen gasförmigen Bestandteilen des Abgases kann vor oder nach der Zirkulationspumpe (32) in Richtung des gepumpten Gases in der Zirkulationseinheit (30) angeordnet sein.

In **Figur 5** ist schematisch eine Ausführungsform der Vorrichtung (1) zur Plasmaprozessierung mit der erfindungsgemäßen Umschalteinheit dargestellt, mit der die Richtung des strömenden Gases in den Plasmaprozesszonen gewechselt werden kann. Dies ist beispielhaft für die in Figur 1 dargestellte Ausführungsform gezeigt, bei der der Gaseinlass (13) nur mit einer Gaszuführungsleitung und der Gasauslass (14) nur mit einer Abgasleitung verbunden sind. Um die Gasströmrichtung umzukehren, das heißt den Gaseinlass und den Gasauslass faktisch miteinander zu tauschen, sind in der Gaszuführungsleitung sowie der Abgasleitung jeweils ein Ventil einer ersten Ventilgruppe (27) und ein Ventil einer zweiten Ventilgruppe (28) angeordnet. Die erste Ventilgruppe (27) und die zweite Ventilgruppe (28) bilden gemeinsam die Umschalteinheit. In einem ersten Schaltzustand sind die Ventile (27a und 27b) der ersten Ventilgruppe (27) geöffnet und die Ventile (28a und 28b) der zweiten Ventilgruppe (28) geschlossen. Damit werden das frische Gas von der Vorrichtung (22) zur Gasbereitstellung und das über die Zirkulationsleitung (31) zurückgeführte Abgas in den Gaseinlass (13) eingespeist und das Abgas über den Gasauslass (14) aus der Prozesskammer abgeführt. In einem zweiten Schaltzustand sind die Ventile (27a und 27b) der ersten Ventilgruppe (27) geschlossen und die Ventile (28a und 28b) der zweiten Ventilgruppe (28) geöffnet. Damit werden das frische Gas von der Vorrichtung (22) zur Gasbereitstellung und das über die Zirkulationsleitung (31) zurückgeführte Abgas in den Gasauslass (14) eingespeist und das Abgas über den Gaseinlass (13) aus der Prozesskammer abgeführt. Vorteilhafterweise sind dafür der Gaseinlass (13) und der Gasauslass (14) baugleich ausgeführt. Durch das Wechseln der Gasströmungsrichtung in den Plasmaprozesszonen (11a bis 11c) können Inhomogenitäten des Plasmaprozesses über die Ausdehnung der Substrate in Strömungsrichtung reduziert werden. Typische Wechselraten der Strömungsrichtung liegen bei 5 bis 25 Wechseln je vollständiger Plasmaprozessierung, beispielsweise je Abscheidung einer bestimmten Schichtdicke auf einem Substrat bei einem Beschichtungsprozess.

Mit Bezug auf die **Figuren 6A bis 6C** werden spezifische Ausführungsbeispiele für die Erzeugung des Plasmas und die elektrische Verschaltung der Substrathalterungen erläutert, wobei das erste Ausführungsbeispiel der erfindungsgemäßen Vorrichtung zur Plasmaprozessierung verwendet wird. Daher sind Details der Gaszuführung und Gasabführung weggelassen worden.

**Figur 6A** zeigt ein Beispiel für eine ungepulste Plasmaerzeugung mittels eines Generators (60), der eine Gleichspannung bereitstellt. In anderen Ausführungsformen kann der Generator (60) eine niederfrequente oder eine hochfrequente Spannung bereitstellen. Die Substrate (12a bis 12c) sind auf sich kammartig erstreckenden Elektroden (121, 122) angeordnet. Dabei erstrecken sich erste Elektroden (121) in die positive x-Richtung, während sich zweite Elektroden (122) in die negative x-Richtung von einer jeweiligen Zuführungsleitung erstrecken. In einer anderen Ausführungsform erstrecken sich die Elektroden (121, 122) in die positive und die negative z-Richtung von einer entsprechenden Zuführungsleitung aus. Die ersten Elektroden (121) und die zweiten Elektroden (122) sind alternierend entlang der y-Richtung angeordnet, wobei die ersten Elektroden (121) elektrisch von den zweiten Elektroden (122) isoliert sind. Der Generator (60) ist symmetrisch mit den ersten und den zweiten Elektroden (121, 122) verbunden. In anderen Ausführungsformen ist der Generator (60) asymmetrisch mit den ersten und den zweiten Elektroden (121, 122) verbunden, wobei die ersten Elektroden (121) oder die zweiten Elektroden (122) mit der Masse der Prozesskammer verbunden sind. Die Elektroden (121, 122) haben eine etwas größere laterale Ausdehnung als die auf ihnen angeordneten Substrate (12a bis 12c) und weisen typerweise Abstände von 1 bis 100 mm zueinander in y-Richtung auf. Zwischen einer ersten Elektrode (121) und einer zu ihr benachbart angeordneten zweiten Elektrode (122) wird bei Anliegen einer Spannung ein Plasma erzeugt, das die Prozessierung des zwischen den Elektroden befindlichen Substrates ermöglicht.

**Figur 6B** zeigt ein Beispiel für eine gepulste Plasmaerzeugung. Dabei sind die ersten Elektroden (121) mit der Masse der Prozesskammer (mit Erde) verbunden, während die zweiten Elektroden (122) mit einer Match- und Filterbox (62) verbunden, an die ein Generator (60) und ein Pulsgenerator (61) angeschlossen sind. Ein derartig erzeugtes gepulstes Plasma kann beispielsweise zur Ionenimplantation mittels Plasma Immersions Implantation genutzt werden. Damit können Dotanden wie Bor oder Phosphor mit Ionenenergien bis ca. 30 keV in ein Substrat implantiert werden. Dazu wird in den Plasmaprozesszonen (11a bis 11c) ein Plasma zum Beispiel mit dem Gas Phosphin (PH3) oder mit Bortrifluorid (BF3) gezündet. Durch Anlegen kurzer negativer Hochspannungsimpulse aus dem Pulsgenerator (61) werden Ionen aus der Plasmarandschicht auf das Substrat beschleunigt.

**Figur 6C** zeigt ein Beispiel für eine Remote Plasmaerzeugung. Für Prozessierungen, bei denen kein Anteil durch die aus dem Plasma auf dem Substrat auftreffenden Ionen notwendig oder erwünscht ist, beispielsweise für reines Radikalätzen oder Oberflächenmodifikationen, sollen die Plasmazone und die Prozessierungzone voneinander getrennt werden. Auch hier ist eine Gaszirkulation, wie sie in den bisherigen Ausführungsbeispielen beschrieben wurde, von Vorteil. Dabei werden die in der Remote Plasmazone (111) erzeugten Radikale und Gasbestandteile gleichmäßig über die verschiedenen Prozessierungszonen (11a bis 11c), die im Prinzip den bisher beschriebenen Plasmaprozesszonen entsprechen, verteilt, so dass eine Reduzierung der Inhomogenitäten zwischen verschiedenen Substraten (12a bis 12c) und über die Ausdehnung eines Substrates hinweg erreicht wird. Das Remote Plasma (111) kann beispielsweise mittels eines Generators (60) erzeugt werden.

Allgemein können das oder die zur Prozessierung genutzten Plasmen Niederdruckplasmen sein, bei denen die notwendige Leistung mittels Elektroden, induktiv, mittels Mikrowellen oder über dielektrische Fenster eingekoppelt werden kann.

Darüber hinaus ist in den Figuren 6A und 6C noch ein Heizelement (15) dargestellt, das die für die Plasmaprozessierung notwendige Substrattemperatur und/oder Gastemperatur gewährleistet. Dies kann beispielsweise über Infrarotstrahlung oder Wärmeleitung realisiert werden. Vorteilhafterweise werden auch in die Gaseinlass-Mischkammer und die Gasauslass-Mischkammer Heizelemente integriert, so dass die Substrate und Plasmaprozesszonen eine homogene Temperaturverteilung aufweisen. Die beschriebenen Heizelemente können in allen Ausführungsformen der erfindungsgemäßen Vorrichtung zur Plasmaprozessierung eingesetzt werden.

Die **Figuren 7A** **und** **7B** zeigen eine vierte Ausführungsform der erfindungsgemäßen Vorrichtung zur Plasmaprozessierung, wobei Fig. 7A eine Draufsicht auf die Vorrichtung und Fig. 7B einen Querschnitt entlang der in Fig. 7A dargestellten Linie B-B' zeigt. In dieser Ausführungsform der erfindungsgemäßen Vorrichtung bewegen sich die Substrate (12a bis 12d) in der Prozesskammer (10) entlang einer ersten Richtung, die im dargestellten Fall der z-Richtung entspricht. Die Bewegung ist mittels der Pfeile symbolisiert. Dabei können mehrere Substrate (12a bis 12d) auf einem Substratträger (120) lateral nebeneinander angeordnet sein. Der Substratträger (120) wird mittels einer Vorrichtung (70) zum Bewegen der Substrate in der Prozesskammer bewegt. Dies können beispielsweise die in Fig. 7B dargestellten Rollen oder auch ein Band oder eine andere Vorrichtung sein. Die Prozesskammer weist mehrere Gaseinlässe (13a, 13b) und mehrere Gasauslässe (14a, 14b) auf, wobei diese alternierend entlang der ersten Richtung auf einer Seite der Prozesskammer angeordnet sind. Wie in Fig. 7B zu sehen ist, sind die Gaseinlässe (13a, 13b) und die Gasauslässe (14a, 14b) entlang der oberen Kammerwand angeordnet. Zwischen einem Gaseinlass (13a, 13b) und seinem benachbarten Gasauslass (14a, 14b) (oder zwei benachbarten Gasauslässen) ist eine Plasmaprozesszone (11a bis 11c) angeordnet, wobei die Substrate (12a bis 12d) unterhalb der Plasmaprozesszonen (11a bis 11c) entlang geführt werden. Daher wird die Substratanordnung der Substrate (12a bis 12d) von den Prozessgasen zwar angeströmt, jedoch nicht durchströmt.

Vorteilhafterweise werden die Abgase, die aus allen in der Prozesskammer (10) befindlichen Gasauslässen (14a, 14b) austreten, miteinander gemischt und allen in der Prozesskammer (10) befindlichen Gaseinlässen (13a, 13b) zugeführt. Jedoch ist es in anderen Ausführungsformen auch möglich, nur die Abgase aus spezifischen Gasauslässen zu mischen und diese nur spezifischen Gaseinlässen zuzuführen. Durch die Mischung der Abgase und deren erneuter Zuführung in die Gaseinlässe werden Prozessgasunterschiede zwischen den einzelnen Plasmaprozesszonen (11a bis 11c) aber auch innerhalb einer spezifischen Plasmaprozesszone ausgeglichen.

**Figur 8** zeigt eine fünfte Ausführungsform der erfindungsgemäßen Vorrichtung zur Plasmaprozessierung in einer Draufsicht auf die Vorrichtung, wobei Figur 1 einen beispielhaften Querschnitt einer solchen Vorrichtung entlang der x-y-Ebene darstellt. Auch hier werden die Substrate entlang der ersten Richtung, das heißt entlang der z-Richtung, in der Prozesskammer (10) bewegt. Jedoch sind die Substrate vertikal, das heißt entlang der y-Richtung, übereinander in einem Substratträger (120) angeordnet, so dass in der Draufsicht nur das oberste Substrat (12a) zu sehen ist. Die Prozesskammer umfasst mehrere Gaseinlässe (13a bis 13c) sowie mehrere Gasauslässe (14a bis 14c), die entlang der ersten Richtung auf gegenüber liegenden Seiten der Prozesskammer angeordnet sind, wobei jedem Gaseinlass ein Gasauslass zugeordnet ist. Dabei ist ein spezifischer Gaseinlass (z. B. 13a) auf einer Seite der Prozesskammer (10) angeordnet, und der diesem spezifischen Gaseinlass zugeordnete Gasauslass (z. B. 14a) ist auf der gegenüberliegenden Seite der Prozesskammer angeordnet. Damit wird die Substratanordnung und die dem jeweiligen Gaseinlass und Gasauslass zugeordnete Plasmaprozesszone (z. B. 11a) von dem Prozessgas durchströmt. Die beiden Seiten der Prozesskammer sind dabei in x-Richtung voneinander beabstandet. In der in Fig. 8 dargestellten Ausführungsform sind alle Gaseinlässe (13a bis 13c) auf einer Seite der Prozesskammer (10) und alle Gasauslässe (14a bis 14c) auf der gegenüberliegenden Seite der Prozesskammer (10) angeordnet.

Jedoch können in anderen Ausführungsformen auch einzelne Paare bestehend aus einem Gaseinlass und einem Gasauslass entgegengesetzt angeordnet sein. Beispielsweise können die Gaseinlässe 13a und 13c auf einer ersten Seite der Prozesskammer (10) angeordnet sein und die dazugehörigen Gasauslässe 14a und 14c auf der gegenüberliegenden zweiten Seite der Prozesskammer (10), während der Gaseinlass 13b auf der zweiten Seite der Prozesskammer (10) und der dazugehörige Gasauslass 14b auf der ersten Seite der Prozesskammer (10) angeordnet sind. Damit kann ein Wechsel der Gasströmrichtung in benachbarten Plasmaprozesszonen (11a bis 11c) erzielt werden, ohne die in Figur 5 dargestellte Umschalteinheit zu benutzen.

In anderen als den in den Figuren 7A, 7B und 8 dargestellten Ausführungsbeispielen können die Anzahl der Gaseinlässe und Gasauslässe, deren Anordnung bezüglich der Seiten der Prozesskammer (10) sowie die Anzahl der miteinander vermischten Abgase beziehungsweise die Anzahl der miteinander verschalteten Gasauslässe und Gaseinlässe verschieden von denen der in den Figuren dargestellten Ausführungsbeispiele sein.

### Bezugszeichen

- 1: Vorrichtung zur Plasmaprozessierung
- 10: Prozesskammer
- 11a - 11c: Plasmaprozesszone
- 111: Remote Plasma
- 12a - 12d: Substrat
- 120: Substratträger
- 121: Erste Elektroden
- 122: Zweite Elektroden
- 13: Gaseinlass
- 13a - 13c: Unterkammer
- 131a - 131c: Ausströmöffnung
- 132a, b: Trennwand
- 14: Gasauslass
- 141a - 141c: Einströmöffnung
- 15: Heizelement
- 21: Gaszuführungsleitung
- 21a: Erste Gaszuführungsleitung
- 21b: Zweite Gaszuführungsleitung
- 22: Vorrichtung zur Gasbereitstellung
- 23: Abgasleitung
- 23a: Erste Abgasleitung
- 23b: Zweite Abgasleitung
- 24: Pumpe
- 25a, 25b: Regelventil
- 26a - 26f: Dosiereinrichtung
- 27: Erste Ventilgruppe
- 24a, b: Ventile der ersten Ventilgruppe
- 28: Zweite Ventilgruppe
- 28a, b: Ventile der zweiten Ventilgruppe
- 30: Zirkulationseinheit
- 31: Zirkulationsleitung
- 32: Zirkulationspumpe
- 33: Staubabscheidende Vorrichtung
- 34: Vorrichtung zur Entfernung von Gasbestandteilen
- 35: Abführleitung
- 60: Generator
- 61: Pulsgenerator
- 62: Match- und Filterbox
- 70: Vorrichtung zur Bewegung der Substrate

## Patentansprüche

1. Vorrichtung (1) zur Plasmaprozessierung, umfassend:
- eine Prozesskammer (10) mit:
- mindestens zwei von einem Prozessgas durchströmten Plasmaprozesszonen (11a - 11c),
- einem Gaseinlass (13), der geeignet ist, das Prozessgas den mindestens zwei Plasmaprozesszonen (11a - 11c) zuzuführen, und
- einem Gasauslass (14), der geeignet ist, ein Abgas aus der Prozesskammer (10) auszulassen,
**dadurch gekennzeichnet, dass**
- die Vorrichtung weiterhin eine Zirkulationseinheit (30) mit einer Zirkulationsleitung (31) und einer Zirkulationspumpe (32) enthält, wobei die Zirkulationseinheit (30) geeignet ist, mindestens einen Teil des Abgases in den Gaseinlass (13) einzuspeisen, und
- wobei das in den Gaseinlass (13) eingespeiste Abgas eine Mischung von Gasen, die aus mindestens zwei der Plasmaprozesszonen (11a - 11c) austreten, ist,
- der Gaseinlass (13) und der Gasauslass (14) baugleich ausgeführt sind und
- die Vorrichtung zur Plasmaprozessierung eine Umschalteinheit aufweist, die geeignet ist, in einem ersten Schaltzustand das über die Zirkulationsleitung (31) eingespeiste Abgas und ein von dem Abgas verschiedenes eingespeistes Gas dem Gaseinlass (13) zuzuführen und das Abgas vom Gasauslass (14) abzuführen und in einem zweiten Schaltzustand das über die Zirkulationsleitung (31) eingespeiste Abgas und das von dem Abgas verschiedene eingespeiste Gas dem Gasauslass (14) zuzuführen und das Abgas vom Gaseinlass (13) abzuführen..

2. Vorrichtung zur Plasmaprozessierung nach Anspruch 1, **dadurch gekennzeichnet, dass**
- die Zirkulationseinheit (30) ein Regelventil (25a, 25b) umfasst, und
- das Regelventil (25a, 25b) und die Zirkulationspumpe (32) so ausgelegt sind, dass das Verhältnis des Gasstromes des über die Zirkulationsleitung (31) in den Gaseinlass (13) eingespeisten Abgases zu dem Gasstrom des in den Gaseinlass (13) eingespeisten, vom Abgas verschiedenen Gases in einem Bereich kleiner gleich 100, vorzugsweise bei 10 liegt.

3. Vorrichtung zur Plasmaprozessierung nach Anspruch 1 oder 2, **dadurch gekennzeichnet, dass** der Gaseinlass (13) mit einer Gaszuführungsleitung (21) verbunden ist, die an eine Vorrichtung (22) zur Bereitstellung des von dem Abgas verschiedenen Gases angeschlossen ist, wobei die Zirkulationsleitung (31) mit der Gaszuführungsleitung (21) verbunden ist, so dass das von der Zirkulationseinheit (30) zugeführte Abgas über die Gaszuführungsleitung (21) in den Gaseinlass eingespeist wird.

4. Vorrichtung zur Plasmaprozessierung nach Anspruch 1 oder 2, **dadurch gekennzeichnet, dass** der Gaseinlass (13) mit zwei Gaszuführungsleitungen (21a, 21b) verbunden ist, wobei eine erste Gaszuführungsleitung (21a) direkt mit der Zirkulationsleitung (31) und eine zweite Gaszuführungsleitung (21b) mit einer Vorrichtung (22) zur Bereitstellung des von dem Abgas verschiedenen Gases verbunden ist.

5. Vorrichtung zur Plasmaprozessierung nach einem der vorhergehenden Ansprüche, **dadurch gekennzeichnet, dass** der Gaseinlass (13) durch eine Gaseinlass-Mischkammer realisiert ist, die mindestens zwei Ausströmsysteme mit jeweils einer oder mehreren Öffnungen (131a - 131c) aufweist, aus denen das Prozessgas zu den Plasmaprozesszonen (11a - 11c) ausströmt, wobei jedes Ausströmsystem jeweils einer der mindestens zwei Plasmaprozesszonen (11a - 11c) zugeordnet ist.

6. Vorrichtung zur Plasmaprozessierung nach Anspruch 5, **dadurch gekennzeichnet, dass** die Öffnungen (131a - 131c) der mindestens zwei Ausströmsysteme einen gleichen Leitwert aufweisen.

7. Vorrichtung zur Plasmaprozessierung nach Anspruch 4, **dadurch gekennzeichnet, dass** der Gaseinlass (13) durch eine Gaseinlass-Mischkammer realisiert ist, die mindestens zwei Unterkammern (13a - 13c) aufweist, wobei jede Unterkammer (13a - 13c) ein separates Ausströmsystem aufweist, aus dem das Prozessgas zu mindestens einer Plasmaprozesszone (11a - 11c) strömt, jeweils mindestens einer der Plasmaprozesszonen (11a - 11c) zugeordnet ist und wobei jeder Unterkammer (13a - 13c) mindestens eine Dosiereinrichtung (26a - 26f) zugeordnet ist, die geeignet ist, die Menge des eingespeisten Abgases und/oder die Menge des vom Abgas verschiedenen eingespeisten Gases für die jeweilige Unterkammer (13a - 13c) separat einzustellen.

8. Vorrichtung zur Plasmaprozessierung nach einem der vorhergehenden Ansprüche, **dadurch gekennzeichnet, dass** der Gasauslass (14) durch eine Gasauslass-Mischkammer realisiert ist, die mindestens zwei Einströmsysteme mit jeweils einer oder mehreren Öffnungen (141a- 141c) aufweist, durch die das Abgas aus den Plasmaprozesszonen (11a - 11c) in die Gasauslass-Mischkammer einströmt, wobei jedes Einströmsystem jeweils einer der mindestens zwei Plasmaprozesszonen (11a - 11c) zugeordnet ist.

9. Vorrichtung zur Plasmaprozessierung nach Anspruch 8, **dadurch gekennzeichnet, dass** die Öffnungen (141a - 141c) der mindestens zwei Einströmsysteme einen gleichen Leitwert aufweisen.

10. Vorrichtung zur Plasmaprozessierung nach einem der vorhergehenden Ansprüche, **dadurch gekennzeichnet, dass**
- der Gasauslass (14) mit einer Vorrichtung zur Gasabführung über eine Abgasleitung (23) verbunden ist, und
- die Zirkulationsleitung (31) mit der Abgasleitung (23) verbunden ist.

11. Vorrichtung zur Plasmaprozessierung nach einem der Ansprüche 1 bis 9 **dadurch gekennzeichnet, dass** der Gasauslass (14) mit einer Vorrichtung zur Gasabführung über eine Abgasleitung (23) und getrennt davon mit der Zirkulationsleitung (31) verbunden ist.

12. Vorrichtung zur Plasmaprozessierung nach einem der vorhergehenden Ansprüche, **dadurch gekennzeichnet, dass** die Zirkulationseinheit (30) eine staubabscheidende Einrichtung (33) umfasst.

13. Vorrichtung zur Plasmaprozessierung nach einem der vorhergehenden Ansprüche, **dadurch gekennzeichnet, dass** die Zirkulationseinheit (30) eine Vorrichtung (34) zur Entfernung von spezifischen Bestandteilen des Abgases umfasst.

14. Vorrichtung zur Plasmaprozessierung nach einem der vorhergehenden Ansprüche, **dadurch gekennzeichnet, dass** die Umschalteinheit geeignet ist, den Schaltzustand zwischen 5 und 25 mal pro Plasmaprozessierungvorgang zu wechseln.

15. Vorrichtung zur Plasmaprozessierung nach einem der vorhergehenden Ansprüche, **dadurch gekennzeichnet, dass**
- die Vorrichtung zur Plasmaprozessierung weiterhin eine Vorrichtung (70) zum Bewegen einer Anordnung von Substraten (12a - 12d), die in den Plasmaprozesszonen (11a - 11c) bearbeitet werden, entlang einer ersten Richtung in der Prozesskammer (10) aufweist, und
- die Prozesskammer (10) mehrere Gaseinlässe (13) und mehrere Gasauslässe (14) umfasst, wobei die Gaseinlässe (13) und die Gasauslässe (14) alternierend entlang der ersten Richtung auf einer Seite der Prozesskammer (10) angeordnet sind und die Substratanordnung von dem Prozessgas angeströmt, aber nicht durchströmt wird.

16. Vorrichtung zur Plasmaprozessierung nach einem der Ansprüche 1 bis 14, **dadurch gekennzeichnet, dass** der Gaseinlass (13) und der Gasauslass (14) an gegenüberliegenden Seiten der Prozesskammer (10) angeordnet sind.

17. Vorrichtung zur Plasmaprozessierung nach einem der Ansprüche 1 bis 14, **dadurch gekennzeichnet, dass**
- die Vorrichtung zur Plasmaprozessierung weiterhin eine Vorrichtung (70) zum Bewegen einer Anordnung von Substraten (12a - 12d), die in den Plasmaprozesszonen (11a - 11c) bearbeitet werden, entlang einer ersten Richtung in der Prozesskammer (10) aufweist, und
- die Prozesskammer (10) mehrere Paare von Gaseinlässen (13) und diesen zugeordneten Gasauslässen (14) umfasst, wobei die Gaseinlässe (13) und die Gasauslässe (14) entlang der ersten Richtung derart angeordnet sind, dass ein spezifischer Gaseinlass (13) auf einer Seite der Prozesskammer (10), die sich entlang der ersten Richtung erstreckt, und der diesem spezifischen Gaseinlass (13) zugeordnete Gasauslass (14) auf der gegenüberliegenden Seite der Prozesskammer (10) angeordnet sind, so dass die Substratanordnung und die dem jeweiligen Gaseinlass (13) und Gasauslass (14) zugeordneten Plasmaprozesszonen (11a - 11c) von dem Prozessgas durchströmt werden.

18. Vorrichtung zur Plasmaprozessierung nach Anspruch 17, **dadurch gekennzeichnet, dass** die Vorrichtung zur Plasmaprozessierung genauso viele Zirkulationseinheiten (30) wie Paare von Gaseinlässen (13) und diesen zugeordneten Gasauslässen (14) umfasst, wobei jedem spezifischen Paar aus Gaseinlass (13) und zugeordnetem Gasauslass (14) eine Zirkulationseinheit (30) zugeordnet ist und wobei die Abgase aus einem spezifischen Gasauslass (14) durch die zugeordnete Zirkulationseinheit (30) ausschließlich in den zugeordneten Gaseinlass (30) eingespeist werden.

19. Vorrichtung zur Plasmaprozessierung nach Anspruch 17, **dadurch gekennzeichnet, dass** die Abgase aus allen Gasauslässen (14) gemischt und in alle Gaseinlässe (13) eingespeist werden.

20. Vorrichtung zur Plasmaprozessierung nach einem der Ansprüche 17 bis 19, **dadurch gekennzeichnet, dass** die Gaseinlässe (13) und die zugehörigen Gasauslässe (14) von zwei in der ersten Richtung hintereinander angeordneten Paaren von Gaseinlässen (13) und diesen zugeordneten Gasauslässen (14) so angeordnet sind, dass der Gaseinlass (13) des einen Paares auf der selben Seite der Prozesskammer (10) angeordnet ist wie der Gasauslass (14) des anderen Paares.

## Claims

1. Device (1) for plasma processing, comprising:
- a processing chamber (10) with:
- at least two plasma processing zones (11a - 11c) with process gas flowing through them,
- a gas inlet (13) that is suitable for feeding the process gas into the at least two plasma processing zones (11a - 11c), and
- a gas outlet (14) that is suitable for discharging an exhaust gas from the processing chamber (10),
**characterized in that**
- the device further comprises a circulation unit (30) with a circulation line (31) and a circulation pump (32), wherein the circulation unit (30) is suitable for feeding at least a portion of the exhaust gas into the gas inlet (13),
- wherein the exhaust gas fed into the gas inlet (13) is a mixture of gases that are discharged from at least two of the plasma processing zones (11a - 11c),
- the gas inlet (13) and the gas outlet (14) have an identical design and
- the device for plasma processing has a changeover unit that is suitable, in a first switching state, to supply the gas inlet (13) with exhaust gas fed in through the circulation line (31) and a fed-in gas differing from the exhaust gas, and to discharge the exhaust gas from the gas outlet (14), and, in a second switching state, to supply the gas outlet (14) with exhaust gas fed in through the circulation line (31) and the fed-in gas differing from the exhaust gas, and to discharge the exhaust gas from the gas inlet (13).

2. Device for plasma processing according to claim 1, **characterized in that**
- the circulation unit (30) includes a control valve (25a, 25b), and
- the control valve (25a, 25b) and the circulation pump (32) are designed in such a way that the ratio of the gas flow of the exhaust gas fed into the gas inlet (13) via the circulation line (31) to the gas flow of the gas fed into the gas inlet (13) and differing from the exhaust gas is in a range less than or equal to 100, preferably 10.

3. Device for plasma processing according to claim 1 or 2, **characterized in that** the gas inlet (13) is connected to a gas supply line (21) that is connected to a device (22) for providing the gas differing from the exhaust gas, wherein the circulation line (31) is connected to the gas supply line (21) so that the exhaust gas supplied by the circulation unit (30) is fed into the gas inlet via the gas supply line (21).

4. Device for plasma processing according to claim 1 or 2, **characterized in that** the gas inlet (13) is connected to two gas supply lines (21a, 21b), wherein a first gas supply line (21a) is directly connected to the circulation line (31) and a second gas supply line (21b) is connected with a device (22) for providing the gas differing from the exhaust gas.

5. Device for plasma processing according to one of the preceding claims, **characterized in that** the gas inlet (13) is realized by a gas inlet mixing chamber that has at least two discharge systems, each with one or more openings (131a - 131c), from which the process gas flows to the plasma processing zones (11a - 11c), wherein each discharge system is assigned in each case to one of the at least two plasma processing zones (11a - 11c).

6. Device for plasma processing according to claim 5, **characterized in that** the openings (131a - 131c) of the at least two discharge systems have an identical key value.

7. Device for plasma processing according to claim 4, **characterized in that** the gas inlet (13) is realized by a gas inlet mixing chamber that has at least two sub-chambers (13a - 13c), wherein each sub-chamber (13a - 13c) has a separate discharge system from which the process gas flows to at least one plasma processing zone (11a - 11c) and which is assigned to at least one of the plasma processing zones (11a - 11c) in each case, wherein each sub-chamber (13a - 13c) is assigned to at least one dispensing unit (26a - 26f) that is suitable for separately adjusting the fed-in exhaust gas and/or the quantity of the fed-in gas differing from the exhaust gas for the respective sub-chamber (13a - 13c).

8. Device for plasma processing according to one of the preceding claims, **characterized in that** the gas outlet (14) is realized by a gas outlet mixing chamber that has at least two intake systems, each with one or several openings (141a - 141c) through which the exhaust gas from the plasma processing zones (11a -11c) flows into the gas outlet mixing chamber, wherein each intake system is assigned to one of the at least two plasma processing zones (11a - 11c).

9. Device for plasma processing according to claim 8, **characterized in that** the openings (141a - 141c) of the at least two intake systems have an identical key value.

10. Device for plasma processing according to one of the preceding claims, **characterized in that**
- the gas outlet (14) is connected to a device for discharging gas through an exhaust gas line (23), and
- the circulation line (31) is connected to the exhaust gas line (23).

11. Device for plasma processing according to one of the claims 1 to 9, **characterized in that** the gas outlet (14) is connected to a device for gas discharge through an exhaust gas line (23) and, separately from that, is connected to the circulation line (31).

12. Device for plasma processing according to one of the preceding claims, **characterized in that** the circulation unit (30) includes a dust-collection device (33).

13. Device for plasma processing according to one of the preceding claims, **characterized in that** the circulation unit (30) includes a device (34) for removing specific components of the exhaust gas.

14. Device for plasma processing according to one of the preceding claims, **characterized in that** the changeover unit is suitable for changing the switching state between 5 and 25 times per plasma processing event.

15. Device for plasma processing according to one of the preceding claims, **characterized in that**
- the device for plasma processing has, moreover, a device (70) for moving an arrangement of substrates (12a - 12d) that are processed in the plasma processing zones (11a - 11c) along a first direction in the processing chamber (10) and
- the processing chamber (10) includes several gas inlets (13) and several gas outlets (14), wherein the gas inlets (13) and the gas outlets (14) are arranged in an alternating fashion along the first direction on one side of the processing chamber (10) and the process gas flows to the substrate arrangement, but not through it.

16. Device for plasma processing according to one of the claims 1 to 14, **characterized in that** the gas inlet (13) and the gas outlet (14) are arranged on opposite sides of the processing chamber (10).

17. Device for plasma processing according to one of the claims 1 to 14, **characterized in that**
- the device for plasma processing has, moreover, a device (70) for moving an arrangement of substrates (12a - 12d) that are processed in the plasma processing zones (11a - 11c) along a first direction in the processing chamber (10) and
- the processing chamber (10) includes several pairs of gas inlets (13) and gas outlets (14) assigned to them, wherein the gas inlets (13) and the gas outlets (14) are arranged along the first direction to the effect that a specific gas inlet (13) is arranged on one side of the processing chamber (10) that extends along a first direction and the gas outlet (14) assigned to this specific gas inlet (13) is arranged on the opposite side of the processing chamber (10) so that the process gas flows through the substrate arrangement and the plasma processing zones (11a - 11c) assigned to the respective gas inlet (13) and gas outlet (14).

18. Device for plasma processing according to claim 17, **characterized in that** the device for plasma processing comprises exactly the same number of circulation units (30) as there are pairs of gas inlets (13) and gas outlets (14) assigned to them, wherein a specific circulation unit (30) is assigned to a specific pair made up of a gas inlet (13) and an assigned gas outlet (14) and wherein the exhaust gases from a specific gas outlet (14) are exclusively fed into the assigned gas inlet (13) via the assigned circulation unit (30).

19. Device for plasma processing according to claim 17, **characterized in that** the exhaust gases from all of the gas outlets (14) are mixed and fed into all of the gas inlets (13).

20. Device for plasma processing according to one of the claims 17 to 19, **characterized in that** the gas inlets (13) and the accompanying gas outlets (14) of two pairs of gas inlets (13) and gas outlets (14) assigned to them that are arranged in back of one another in the first direction are arranged in such a way that the gas inlet (13) of the one pair is located on the same side of the processing chamber (10) as the gas outlet (14) of the other pair.

## Revendications

1. Dispositif (1) de traitement au plasma comprenant :
- une chambre de traitement (10) pourvue :
- d'au moins deux zones de traitement au plasma (11a-11c) traversées par un gaz de traitement,
- d'une entrée de gaz (13) appropriée pour amener le gaz de traitement aux au moins deux zones de traitement au plasma (11a-11c), et
- d'une sortie de gaz (14) appropriée pour faire sortir un gaz d'échappement de la chambre de traitement (10),
**caractérisé en ce que**
- le dispositif comprend en outre une unité de circulation (30) munie d'un conduit de circulation (31) et d'une pompe de circulation (32), l'unité de circulation (30) étant adaptée pour introduire au moins une partie du gaz d'échappement dans l'entrée de gaz (13), et
- le gaz d'échappement introduit dans l'entrée de gaz (13) étant un mélange de gaz sortant d'au moins deux des zones de traitement au plasma (11a-11c),
- l'entrée de gaz (13) et la sortie de gaz (14) étant conçues pour être structurellement identiques et
- le dispositif de traitement au plasma comportant une unité de commutation adaptée, dans un premier état de commutation, pour amener à l'entrée de gaz (13) le gaz d'échappement introduit par le biais du conduit de circulation et un gaz introduit différent du gaz d'échappement et pour évacuer le gaz d'échappement de la sortie de gaz (14) et, dans un deuxième état de commutation, pour amener à la sortie de gaz (14) le gaz d'échappement, introduit par le biais du conduit de circulation (31), et le gaz introduit différent du gaz d'échappement et pour évacuer le gaz d'échappement de l'entrée de gaz (13).

2. Dispositif de traitement au plasma selon la revendication 1, **caractérisé en ce que**
- l'unité de circulation (30) comprend une vanne de régulation (25a, 25b), et
- la vanne de régulation (25a, 25b) et la pompe de circulation (32) sont conçues de telle sorte que le rapport du flux du gaz d'échappement, introduit par le biais du conduit de circulation (31) dans l'entrée de gaz (13), au flux du gaz, différent du gaz d'échappement et introduit dans l'entrée de gaz (13), soit dans une gamme inférieure ou égale à 100, de préférence à 10.

3. Dispositif de traitement au plasma selon la revendication 1 ou 2, **caractérisé en ce que** l'entrée de gaz (13) est reliée à un conduit d'amenée de gaz (21) qui est raccordé à un dispositif (22) d'approvisionnement du gaz différent du gaz d'échappement, le conduit de circulation (31) étant reliée au conduit d'amenée de gaz (21) de sorte que le gaz d'échappement amenée par l'unité de circulation (30) soit introduit dans l'entrée de gaz par le biais du conduit d'amenée de gaz (21).

4. Dispositif de traitement au plasma selon la revendication 1 ou 2, **caractérisé en ce que** l'entrée de gaz (13) est reliée à deux conduits d'amenée de gaz (21a, 21b), un premier conduit d'amenée de gaz (21a) étant relié directement au conduit de circulation (31) et un deuxième conduit d'amenée de gaz (21b) étant relié à un dispositif (22) d'approvisionnement du gaz différent du gaz d'échappement.

5. Dispositif de traitement au plasma selon l'une des revendications précédentes, **caractérisé en ce que** l'entrée de gaz (13) est réalisée par une chambre de mélange d'entrée de gaz, qui comportent au moins deux systèmes de sortie pourvus chacun d'au moins un orifice (131a-131c) duquel le gaz de traitement sort en direction des zones de traitement au plasma (11a-11c), chaque système de sortie étant associé à l'un des au moins deux zones de traitement au plasma (11a-11c).

6. Dispositif de traitement au plasma selon la revendication 5, **caractérisé en ce que** les orifices (131a-131c) des au moins deux systèmes de sortie ont une même conductance fluidique.

7. Dispositif de traitement au plasma selon la revendication 4, **caractérisé en ce que** l'entrée de gaz (13) est réalisée par une chambre de mélange à entrée de gaz qui comporte au moins deux sous-chambres (13a-13c), chaque sous-chambre (13a-13c) comportant un système de sortie séparé duquel le gaz de traitement s'écoule en direction d'au moins une zone de traitement au plasma (11a-11c), chacune d'elle étant associée à au moins une des zones de traitement au plasma (11a-11c) et chaque sous-chambre (13a-13c) étant associée à au moins un moyen de dosage (26a-26f) qui est adapté pour ajuster séparément la quantité de gaz d'échappement introduit et/ou la quantité de gaz introduit, différent du gaz d'échappement, pour la sous-chambre (13a-13c) respective.

8. Dispositif de traitement au plasma selon l'une des revendications précédentes, **caractérisé en ce que** la sortie de gaz (14) est réalisée par une chambre de mélange de sortie de gaz qui comporte au moins deux système d'entrée pourvu chacun d'au moins un orifice (141a-141c) par lequel le gaz d'échappement s'écoule des zones de traitement au plasma (11a-11c) jusque dans la chambre de mélange de sortie de gaz, chaque système d'entrée étant associé à une des au moins deux zones de traitement au plasma (11a-11c).

9. Dispositif de traitement au plasma selon la revendication 8, **caractérisé en ce que** les orifices (141a-141c) des au moins deux systèmes d'entrée ont une même conductance fluidique.

10. Dispositif de traitement au plasma selon l'une des revendications précédentes, **caractérisé en ce que**
- la sortie de gaz (14) est reliée à un dispositif d'évacuation de gaz par le biais d'un condit de gaz d'échappement (23), et
- le conduit de circulation (31) est raccordé au conduit de gaz d'échappement (23).

11. Dispositif de traitement au plasma selon l'une des revendications 1 à 9, **caractérisé en ce que** la sortie de gaz (14) est reliée à un dispositif d'évacuation de gaz par le biais d'un conduit de gaz d'échappement (23) et, séparément de celui-ci, au conduit de circulation (31).

12. Dispositif de traitement au plasma selon l'une des revendications précédentes, **caractérisé en ce que** l'unité de circulation (30) est une moyen de dépoussiérage (33).

13. Dispositif de traitement au plasma selon l'une des revendications précédentes, **caractérisé en ce que** l'unité de circulation (30) comprend un dispositif (34) destiné à éliminer des constituants spécifiques du gaz d'échappement.

14. Dispositif de traitement au plasma selon l'une des revendications précédentes, **caractérisé en ce que** l'unité de commutation est adaptée pour changer l'état de commutation entre 5 et 25 fois par opération de traitement au plasma.

15. Dispositif de traitement au plasma selon l'une des revendications précédentes, **caractérisé en ce que**
- le dispositif de traitement au plasma comprend en outre un dispositif (70) destiné à déplacer un ensemble de substrats (12a-12d), traités dans les zones de traitement au plasma (11a-11c), dans une première direction dans la chambre de traitement (10) et
- la chambre de traitement (10) comporte une pluralité d'entrées de gaz (13) et une pluralité de sorties de gaz (14), les entrées de gaz (13) et les sorties de gaz (14) étant disposées de manière alternée le long de la première direction sur un côté de la chambre de traitement (10) et l'ensemble de substrats étant soufflé mais n'étant pas traversé par le gaz de traitement.

16. Dispositif de traitement au plasma selon l'une des revendications 1 à 14, **caractérisé en ce que** l'entrée de gaz (13) et la sortie de gaz (14) sont disposés sur des côtés opposés de la chambre de traitement (10).

17. Dispositif de traitement au plasma selon l'une des revendications 1 à 14, **caractérisé en ce que**
- le dispositif de traitement au plasma comprend en outre un dispositif (70) destiné à déplacer un ensemble de substrats (12a-12d), traités dans les zones de traitement au plasma (11a-11c), le long d'une première direction dans la chambre de traitement (10) et
- la chambre de traitement (10) comprend une pluralité de paires d'entrées de gaz (13) et de sorties de gaz (14) associées à celles-ci, les entrées de gaz (13) et les sorties de gaz (14) étant disposées le long de la première direction de telle sorte qu'une entrée de gaz spécifique (13) étant disposée d'un côté de la chambre de traitement (10), s'étendant le long de la première direction, et la sortie de gaz (14), associée à cette entrée de gaz spécifique (13), étant disposée du côté opposé de la chambre de traitement (10) de telle sorte que l'ensemble de substrats et les zones de traitement au plasma (11a-11c), associées à l'entrée de gaz (13) et à la sortie de gaz (14) respectives, soient traversées par le gaz de traitement.

18. Dispositif de traitement au plasma selon la revendication 17, **caractérisé en ce que** le dispositif de traitement au plasma comprend autant d'unités de circulation (30) que de paires d'entrées de gaz (13) et de sorties de gaz (14) associées à celles-ci, chaque paire spécifique d'entrée de gaz (13) et de sortie de gaz (14) associées étant associée à une unité de circulation (30) et les gaz d'échappement en provenant d'une sortie de gaz (14) spécifique étant introduits, par le biais de l'unité de circulation (30) associée, exclusivement dans l'entrée de gaz (30) associée.

19. Dispositif de traitement au plasma selon la revendication 17, **caractérisé en ce que** les gaz d'échappement en provenance de toutes les sorties de gaz (14) sont mélangés et sont introduits dans toutes les entrées de gaz (13).

20. Dispositif de traitement au plasma selon l'une des revendications 17 à 19, **caractérisé en ce que** les entrées de gaz (13) et les sorties de gaz (14) associées de deux paires, disposées l'une derrière l'autre dans la première direction, d'entrées de gaz (13) et de sorties de gaz (14) associées à celles-ci sont disposées de telle sorte que l'entrée de gaz (13) de l'une des paires soit disposée du même côté de la chambre de traitement (10) que la sortie de gaz (14) de l'autre paire.
